# EUROPEAN PATENT APPLICATION

(11) **EP 2 299 784 A1**
(43) Date of publication of application: **23.03.2011**
(21) Application number: 09766604.4
(22) Date of filing: 15.06.2009
(51) Int. Cl.: H05B 33/10, B41M 5/26, B44C 1/17, H01L 21/336, H01L 29/786, H01L 51/05, H01L 51/40, H01L 51/50

(54) **PATTERNING METHOD, DEVICE MANUFACTURING METHOD USING THE PATTERNING METHOD, AND DEVICE**

(30) Priority: 16.06.2008 JP 2008156282
(71) Applicant: Toray Industries, Inc., Tokyo 103-8666 (JP)
(72) Inventor: FUJIMORI, Shigeo, Otsu-shi Shiga 520-8558 (JP); SHIRASAWA, Nobuhiko, Otsu-shi Shiga 520-8558 (JP); TANIMURA, Yasuaki, Otsu-shi Shiga 520-8558 (JP)
(74) Representative: Hager, Thomas Johannes
(86) International application number: PCT/JP2009/060824
(87) International publication number: WO 2009/154156

(57) **Abstract**

Provided is a patterning method, wherein a donor substrate, in which a light-to-heat conversion layer and a division pattern are formed on a substrate and a transferring material exists within said division pattern, is opposed to a device substrate and said transferring material is transferred on the device substrate by irradiating the light-to-heatconversion layer with light so that at least a part of said transferring material and at least a part of said division pattern are simultaneouslyheated. The patterning method enables large size and highly accurate fine patterning without degrading characteristics of thin films such as organic EL materials.

## Description

### TECHNICAL FIELD

The present invention relates to a patterning method of thin films composing devices such as organic EL devices, organic TFTs, photoelectric conversion devices, various sensors and the like, and a production method of a device using the patterning method.

### BACKGROUND ART

An organic EL device is one in which an electron injected from a cathode and a hole injected from an anode are recombined within an organic emissive layer sandwiched between both electrodes. The studies on this device have been made by many research laboratories since C.W. Tang et al., of Kodak company have shown that the organic EL device emits light at high luminance (refer to Non-patent Document 1).

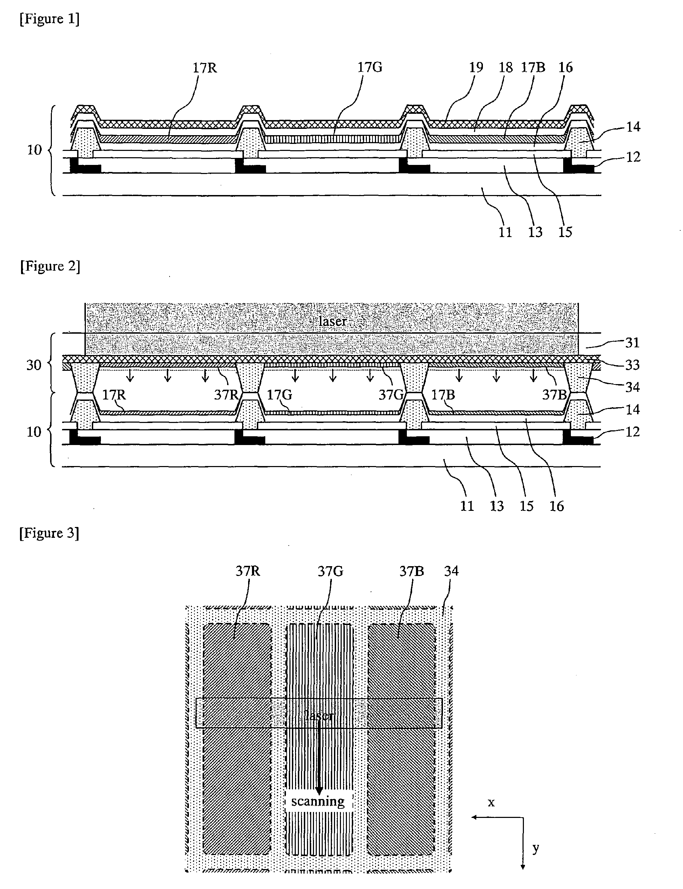

This light emitting device is in an advanced state of commercialization as a color display since it has a low-profile, emits light at high luminance at a low driving voltage and can achieve a variety of emission color including light's three primary colors of red (R), green (G) and blue (B) by using various organic materials for the emissive layer. For example, in an active matrix color display shown in Fig. 1, technology of patterning at least the emissive layers 17R, 17G, and 17B with high precision so as to correspond to R, G, and B subpixels composing pixels is required. Further, a multilayer structure is required for realizing a high performance organic EL device and it is necessary to laminate a hole injection layer, a hole transporting layer, an emissive layer, an electron transporting layer, and an electron injection layer in turn, each of which has a typical film thickness of 0.1 µm or less.

Hitherto, a wet process (application process) such as a photolithographic process, an ink-jet process or a printing process has been used for fine patterning of a thin film. However, in the wet process, it is difficult to prevent morphology changes or undesired mixing of the extremely thin underlayer completely in applying a photoresist or ink onto an underlayer formed in advance, and usable materials for the process are limited. It is difficult to attain the uniformity of film thickness of a thin film in a pixel and uniformity between pixels in a substrate formed by drying a solution and there is a problem that, since electric current concentration and device degradation associated with the unevenness of film thickness occur, display performance is degraded.

A mask evaporation process is investigated as a patterning method based on a dry process without using a wet process. Emissive layers of small size organic EL displays in the actual use are patterned almost exclusively by this process. However, in this process, it is difficult to pursue large size and accuracy of fine patterning simultaneously since an evaporation mask needs to bore a precise hole in a metal plate, and it is difficult to apply the process to large size organic EL displays since the close contact between a substrate and the evaporation mask tends to be impaired as the organic EL display becomes larger.

In order to realize large size devices by a dry process, a method, in which the organic EL material on the donor film is previously patterned and the organic EL material is transferred on a device substrate by heating the entire donor film with the organic EL material on the donor film brought into close contact with the device substrate, is disclosed (Patent Document 1). Furthermore, an evaporation and transfer process, in which an organic EL material patterned within a division pattern (bank) is opposed to a device substrate without contacting with the device substrate and the organic EL material is evaporated by heating the entire donor substrate with a hot plate and deposited on the device substrate, is disclosed (Patent Document 2). However, in the above-mentioned methods, since the entire donor substrate is heated and thermally expanded, there is a problem that a relative position of the organic EL material patterned on the donor substrate to the device substrate is changed and the displacement increases as a size of substrate increases, and therefore a highly accurate fine patterning is difficult. Moreover, there is a problem that device performance is degraded since the device substrate closely opposed is heated by radiation or is affected by outgassing from a division pattern when the division pattern is present.

As a method of preventing a displacement of a pattern due to thermal expansion of a donor substrate, selective transfer methods are developed (refer to Patent Documents 3 to 4), in which a light-to-heat conversion layer is formed on the donor substrate and a film of an organic EL material is formed over the entire area thereon by thermal deposition, and a part of the organic EL material formed over the entire area, or a part of red (R), green (G) and blue (B) organic EL materials applied separately without using a division pattern is transferred on a device substrate by use of heat produced by partially irradiating the light-to-heat conversion layer with laser of high intensity. However, since generated heat also diffuses laterally, the organic EL material which is larger in area than an area range of laser irradiation is transferred and a boundary of the transferred organic EL material is not clear. In order to avoid this situation, it is thought to irradiate with laser of high intensity in an extremely short time. However, in this case, since the organic EL material is heated in an extremely short time, it is difficult to control the highest achieving temperature accurately. Thus, there is a problem that a probability that a temperature of the organic EL material reaches above a decomposition temperature increases, resulting in degradation in device performance. Furthermore, since it is necessary to selectively irradiate RGB subpixels with laser, there is a problem that a time to process a substrate is extended as a size of substrate increases and total number of the pixels increases

As another method of preventing a displacement of a pattern due to thermal expansion of a donor substrate, a direct heating transfer method, in which the organic EL material on the donor substrate is directly heated by laser without forming the light-to-heat conversion layer on the donor substrate, is disclosed (refer to Patent Document 5). In Patent Document 5, possibility of a mixed color at the time of patterning is reduced by applying R, G and B organic EL materials separately by using a division pattern. However, since a typical film thickness of the organic EL material is as small as 25 nm, there is a problem that laser reaches the device substrate without being adequately absorbed by the organic EL material and heats a underlayer on the device substrate. Furthermore, laser of high intensity is required in order to heat the organic EL material to a sublimation temperature or higher to adequately transfer the organic EL material. However, since if the division pattern is irradiated with laser, the division pattern is degraded, it is necessary to position the laser with high accuracy so that only the organic EL material is irradiated with laser for the prevention of degradation and therefore a large size organic EL display was difficult.

Moreover, a method, in which a displacement of a pattern due to thermal expansion of a donor substrate is prevented by forming a light-to-heat conversion layer on the donor substrate, applying red (R), green (G) and blue (B) organic EL materials separately onto the light-to-heat conversion layer, and irradiating the light-to-heat conversion layer with laser light to transfer the R, G and B organic EL materials by one operation, is disclosed (refer to Patent Document 6). However, since the division pattern is not formed on the donor substrate, there are problems that an R organic EL material, a G organic EL material, or a B organic EL material is mixed with an adjoining material when applying these materials in a state of solution or the adjoining material is dissolved again in a solvent vapor produced during drying the organic EL material and it was difficult to apply organic EL materials separately with high accuracy.

### Prior Art Documents

### Patent Documents

Patent Document 1: Japanese Unexamined Patent Publication No. 2002-260854
Patent Document 2: Japanese Unexamined Patent Publication No. 2000-195665
Patent Document 3: Japanese Patent Publication No. 3789991
Patent Document 4: Japanese Unexamined Patent Publication No. 2005-149823
Patent Document 5: Japanese Unexamined Patent Publication No. 2004-87143
Patent Document 6: Japanese Unexamined Patent Publication No. 2008-235011

### Non-Patent Document

Non-patent Document 1: Applied Physics Letters, (US), 1987, Vol. 51, No. 12, 913-915

### DISCLOSURE OF THE INVENTION

### PROBLEMS TO BE SOLVED BY THE INVENTION

As described above, in conventional technologies, it was difficult to realize fine patterning stably without damaging to organic EL materials while pursuing large size and accuracy of fine patterning simultaneously. Particularly, it is an incompatible combination because the combination induces degradation of a division pattern, outgassing from a division pattern or temperature unevenness of a transferring material that a laser transfer process is applied to a donor substrate having the division pattern.

It is an object of the present invention to solve these problems and provide a patterning method enables large size and highly accurate fine patterning without degrading characteristics of thin films such as organic EL materials, a production method of a device using the patterning method, and a device.

### MEANS FOR SOLVING THE PROBLEMS

The present invention has been made by making intense investigations so that conventional problems can be solved even though a transfer process by laser is used to a donor substrate having a division pattern, which can have a detrimental effect such as outgassing.

That is, the patterning method of the present invention pertains to a patterning method, wherein a donor substrate, in which a light-to-heat conversion layer and a division pattern are formed on a substrate and a transferring material exists within the above-mentioned division pattern, is opposed to a device substrate and the above-mentioned transferring material is transferred on the device substrate by irradiating the light-to-heat conversion layer with light so that at least a part of the above-mentioned transferring material and at least apart of the above-mentioned division pattern are simultaneously heated.

### EFFECTS OF THE INVENTION

The present invention provides a marked effect of enabling large size and highly accurate fine patterning without damaging to thin films such as organic EL materials.

### BRIEF DESCRIPTION OF THE DRAWINGS

Fig. 1 is a sectional view showing an example of an organic EL device in which an emissive layer is patterned according to the present invention.
Fig. 2 is a sectional view showing an example of a patterning method of an emissive layer of an organic EL device according to the present invention.
Fig. 3 is a plane view showing an example of the method of light-irradiation in Fig. 2.
Figs. 4(a) and 4(b) are a sectional view illustrating a problem in a conventional arrangement of light-irradiation
Fig. 5 is a plane view illustrating a problem in a conventional donor substrate.
Figs. 6(a) to 6(d) are a sectional view showing an example of a patterning method according to the present invention.
Fig. 7 is a sectional view showing another example of a patterning method according to the present invention.
Fig. 8 is a sectional view showing an example of a patterning method of transferring by one operation in accordance with the present invention.
Figs. 9(a) and 9(b) are a perspective view showing another example of the method of light-irradiation in the present invention.
Figs. 10(a) and 10(b) are a perspective view showing another example of the method of light-irradiation in the present invention.
Fig. 11 is a perspective view showing another example of the method of light-irradiation in the present invention.
Fig. 12 is a perspective view showing another example of the method of light-irradiation in the present invention.
Figs. 13(a) and 13(b) are a sectional view showing an example of the method of overlap light-irradiation in the present invention.
Fig. 14 is a sectional view showing another example of a patterning method of transferring by one operation in accordance with the present invention.
Fig. 15 is a plane view showing another example of the method of light-irradiation in the present invention.
Fig. 16 is a plane view showing another example of the method of light-irradiation in the present invention.
Fig. 17 is a plane view showing another example of the method of light-irradiation in the present invention.
Figs. 18(a) and 18(b) are a perspective view showing another example of the method of light-irradiation in the present invention.
Figs. 19(a) and 19(b) are graphs showing a distribution of light intensity and a temporal change of a transferring material temperature in the present invention.
Figs. 20(a) to 20(d) are a perspective view showing an example of a method for forming irradiation light into a shape in the present invention.
Figs. 21(a) and 21(b) is a sectional view showing an example of a transfer assist layer in the present invention.
Fig. 22 is a sectional view showing another example of a division pattern in the present invention.
Fig. 23 is a sectional view showing another example of a patterning method according to the present invention.
Fig. 24 is a sectional view showing an example of an emissive layer of the organic EL device patterned according to the present invention.
Fig. 25 is a sectional view showing an example of an emissive layer of the organic EL device patterned by a conventional application method.
Fig. 26 is a sectionalview showing an example of an emissive layer of the organic EL device patterned by a conventional mask evaporation process.

### BEST MODE FOR CARRYING OUT THE INVENTION

Figs. 2 and 3 are a sectional view and a plane view, respectively, showing an example of a patterning method of a thin film of the present invention. In addition, in many drawings used herein, aminimumunit of RGB subpixels composing many pixels in a color display is extracted and shown. Further, for easier comprehension, a scale factor in a vertical direction (direction perpendicular to a substrate) is larger than that in a horizontal direction (in-plane direction of a substrate).

In Fig. 2, a donor substrate 30 comprises a support 31, a light-to-heat conversion layer 33, a division pattern 34, and a transferring material 37 (a film formed by applying red, green and blue emissive materials of organic EL) existing in the division pattern. An organic EL device (device substrate) 10 comprises a support 11, a TFT (including a contact electrode) 12 formed thereon, a planarization layer 13, an insulating layer 14, a first electrode 15, and a hole transporting layer 16. In addition, since these are exemplifications, the constitution of the respective substrates is not limited to this as described later. In a state in which a position of the division pattern 34 of the donor substrate 30 is aligned with that of the insulating layer 14 of the device substrate 10, both substrate are arranged to be opposed to each other. Laser enters from a side of the support 31 of the donor substrate 30 and is absorbed by the light-to-heat conversion layer 33, and the transferring materials 37R, 37G and 37B are simultaneously heated and evaporated by heat generated at the light-to-heat conversion layer 33 and these evaporated transferring material are deposited on the hole transporting layer 16 of the device substrate 10, and thereby the emissive layers 17R, 17G and 17B are transferred and formed by one operation. Aspects in Figs. 2 and 3 are characterized in that the light-to-heat conversion layer is irradiated with laser so that the entire areas of a division pattern 34 sandwiched between the transferring materials 37R, 37G and 37B and a partial area of the division pattern 34 which is located at the outside of the transferring materials 37R and 37B are heated concurrently with the transferring material 37.

It is inherently unfavorable to thus form the division pattern, which is a foreign material other than the transferring material, on the donor substrate since there is a possibility that the division pattern itself is peeled off to be transferred or impurities from the division pattern is mixed in the transferring material. Despite this, the division pattern which is a foreign material is irradiated with light so as to positively heat the division pattern in a method in which the transferring material is heated to a relatively high temperature like an evaporation and transfer process in which the light-to-heat conversion layer is disposed on the donor substrate to absorb light and the transferring material is transferred by heat generated. There is no precedent for this sort of method because this method was thought to degrade potentially device performance.

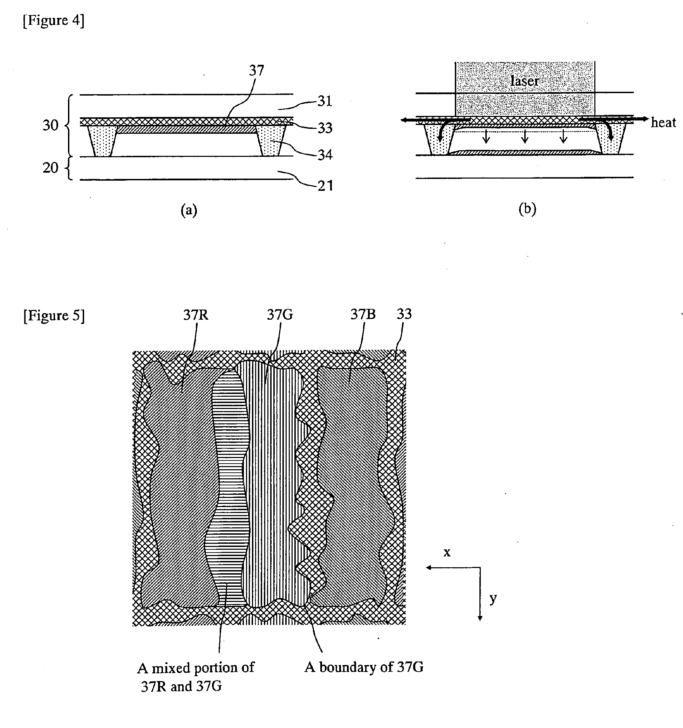

However, the present invention dares to irradiate the light-to-heat conversion layer formed on the donor substrate with light so that the division pattern is heated simultaneously with the transferring material and thereby first enables highly precise patterning. That is, in accordance with such an irradiation process, since a reduction in temperature at a boundary between the division pattern and the transferring material, shown in Fig. 4, is suppressed, the transferring material existing at the boundary can be adequately heated to be transferred. Accordingly, since a film thickness distribution of a transferred thin film becomes more uniform than conventional one, a detrimental effect on the device performance can be prevented. Further, it was found that intensity of light to be used can be lowered in the present invention. Therefore, detachment of the division pattern or a detrimental effect on the device performance resulting from outgassing from the division pattern can be minimized even when irradiated so that the transferring material and the division pattern are simultaneously heated.

Furthermore, in the case where the division pattern having a thickness which is larger than that of the transferring material by a certain length is formed as a preferable aspect of the present invention, a temperature of a portion of the division pattern corresponding to the certain length is not so elevated. Therefore, the device substrate is not heated to elevated temperature by heat through the division pattern, is little affected by outgassing from the division pattern, and device performance is not degraded.

In accordance with the preferable aspect of the present invention, since different transferring materials existing in areas partitioned with a division pattern are simultaneously irradiated andheatedwith light applied extending over different transferring materials, the different transferring materials can be transferred by one operation. For example, when the RGB emissive layers in an organic EL display shown in Fig. 1 are patterned in accordance with the present invention, since the RGB emissive layers can be collectively transferred as a set of transferring materials, a patterning time can be shortened compared with the conventional methods in which each of the RGB emissive layers needs to be transferred in turn. Since the light is adequately absorbed by the light-to-heat conversion layer, temperatures of the RGB emissive layers having different photo absorption spectra can be roughly equated using the same light source and there is no possibility that the device substrate is heated by transmitted light

When the division pattern does not exist, as shown in Fig. 5, there are problems that a portion where different transferring materials (37R and 37G in this example) adjacent to each other are mixed with each other is produced or a position of a boundary of the transferring material (for example, 37G) is not adequately controlled. If the division pattern exists, since the formation of the above-mentioned incomplete portion is prevented, device performance is not impaired in transferring the transferring materials by one operation. Further, since the division pattern can be patterned with high precision by a photolithographic process, a gap of a transferred pattern of the different transferring materials can be minimized. This increases an aperture ratio and leads to the advantage that an organic EL display having excellent durability can be prepared.

Fig. 3 is a schematic view of a situation of laser-irradiation in Fig. 2 as viewed from the support 31 side of the donor substrate 30. Since there is the light-to-heat conversion layer 33 formed over the entire area, the division pattern 34 and the transferring materials 37R, 37G and 37B cannot be actually seen from the support 31 (glass plate) side, but these are shown by the dotted lines for illustration of a positional relationship with laser. A laser beam has a rectangle shape, and the transferring material 37 is irradiated with laser extending over the transferring materials 37R, 37G and 37B and scanned in a direction perpendicular to the sequence of 37R, 37G and 37B. In addition, the scanning may be relatively performed with laser, and the laser may be moved, or a set of the donor substrate 30 and the device substrate 20 may be moved, or both may be moved.

Hereinafter, the present invention will be described in more detail.

### (1) Irradiation light

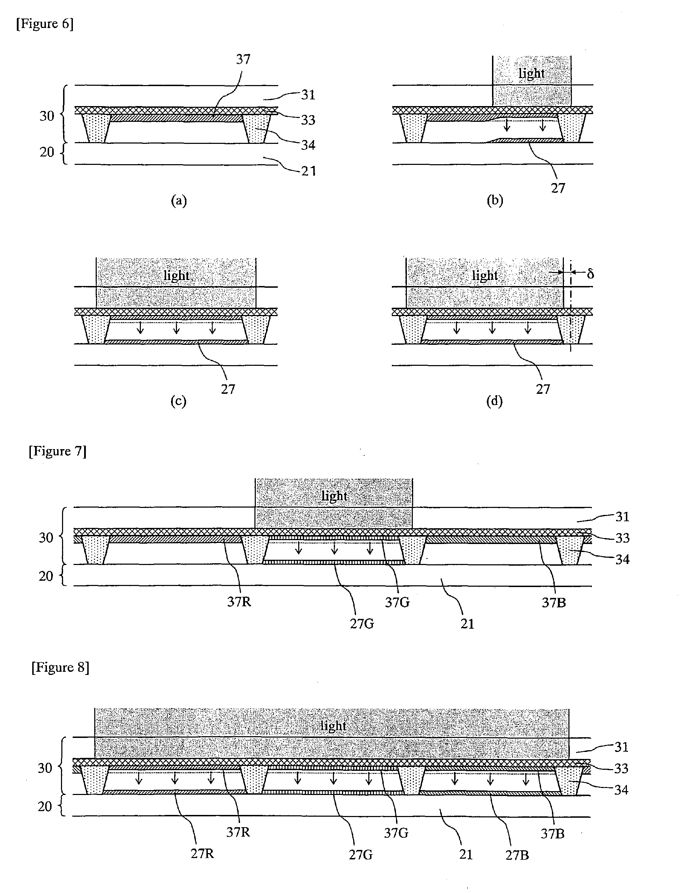

Fig. 6 is a sectional view showing an example of a method for irradiating the donor substrate with light in the present invention. In Fig. 6(a), the donor substrate 30 comprises the support 31, the light-to-heat conversion layer 33 , the division pattern 34, and one type of the transferring material 37 existing within the division pattern, and the transferring substrate 20 comprises only the support 21. As shown in Fig. 6(b), the present invention is characterized in that light typified by laser enters from a side of the support 31 of the donor substrate 30 and the light-to-heat conversion layer 33 is irradiated with the light so that at least a part of the transferring material 37 and at least apart of the division pattern 34 are simultaneously heated. By using such an arrangement, a reduction in temperature at a boundary between the division pattern 34 and the transferring material 37 is suppressed, and therefore the transferring material existing at the boundary can be adequately heated to be transferred and a uniform transferred layer 27 can be obtained.

Fig. 6(b) schematically shows a process in which the transferring material 37 is heated, evaporated and deposited on the support 21 of the transfer substrate 20 as a transferred layer 27. The light-irradiation can be stopped (light-irradiation of this part can be terminated by movement of a light-irradiation section) at this point of time, or the light-irradiation can be still continued to transfer all of a right side portion of the transferring material 3 7 and thereafter a left side portion can be transferred. In the present invention, if the material or the conditions of light-irradiation is selected, an ablation mode, in which the transferring material 37 reaches the support 21 of the transferring substrate 20 with its film form maintained, can be employed. However, from the viewpoint of reducing the damages to materials, it is more preferred to use a deposition mode in which the transferring material 37 is evaporated in a state of disentangling to 1 to 100 molecules (atoms) and transferred.

Fig. 6(c) shows one preferable aspect of the present invention, in which a light-to-heat conversion layer 33 is irradiated with a light, a width of which is wider than a width of a transferring material 37 so that a full width of the transferring material 37 and a part of the width of the division pattern 34 are simultaneously heated. According to this arrangement, a desired pattern of a transferred layer 27 can be efficiently obtained by one operation. Alternatively, by transferring a half of the film thickness of the transferring material 37 by the first light-irradiation and transferring the remaining half by the second light-irradiation, the burden on the transferring material 37 can be more reduced.

A process, in which by repeating light irradiation of the light-to-heat conversion layer 33 plural times for one donor substrate 30, the transferringmaterial 37 is transferreddivided in multiple steps in a thickness direction is a particularly preferable transfer method of the present invention. Thereby, since the highest achieving temperature of not only the transferring material 37 but also the division pattern 34 and the underlayer formed on the device substrate 20 can be lowered, damages to the donor substrate and a reduction in device performance can be prevented. When the transferring material is divided in a thickness direction, the number n of divisions is not particularly limited, but if it is too few, the above-mentioned reduction in temperature is not adequately achieved, and if it is too many, a cumulative heating time is long and causes adverse effects. Therefore, the number n of divisions is preferably 5 or more and 50 or less.

In the conventional method in which only a transferring material corresponding to one pixel is partially transferred, even if the transferring material is transferred in n steps in a thickness direction, the effect of inhibiting material degradation can be achieved, but there is a problem that the productivity is significantly reduced since a processing time per substrate increases approximately by a factor of n. However, in the present invention, m (m is an integer of 2 or more) transferring materials can also be transferred by one operation, the productivity can be maintained. Particularly, when a wide light, which satisfies the condition of m ≥ n, is used, it is preferred since it is possible to secure high productivity which is equal to or higher than the conventional method. Inproduction of a display, even a large size substrate needs to be processed in about 2 minutes per substrate. Considering that if the scanning speed of laser is 0.6 m/s of standard level and a length of the substrate is 3 m, 24 scanning (12 reciprocating motions) takes two minutes, the number n of divisions is particularly preferably 15 or more and 30 or less.

It is not uncommon that the transferring materials 37R, 37G and 37B have different temperature characteristics of an evaporation rate. Accordingly, for example, as shown in Fig. 2, when the transferring material is irradiated with a uniform light bundle having a wide width, the entire film thickness of the transferring material 37B can be transferred but the transferring materials 37R and 37G can be each transferred by a half of the film thickness by the first light-irradiation. In this case, the rests of the film thicknesses of the transferring materials 37R and 37G can be transferred completely by the second light-irradiation. At this time, the transferring materials 37B does not exist on the donor substrate 30 after the first light-irradiation, but the second light-irradiation can be carried out in the same arrangement as in the first light-irradiation. Under the same consideration, for example, the 37R, 37G, and 37B can be transferred in 10 steps, 7 steps, and 5 steps, respectively. Further, a donor substrate in which the transferring material 37B is never formed and only the transferring materials 37R and 37G are formed can also be used.

When the transferring materials 37R, 37G and 37B are a emissive material of the organic EL device, it is not uncommon that the transferring material is a mixture of a host material and a dopant material as described later and these transferring materials have different temperature characteristics of an evaporation rate. For example, when an evaporation temperature of the dopant material is lower than that of the host material, if the transferring material is heated at low temperature for a long time, a phenomenon in which all of the dopant material is evaporated first tends to occur. On the other hand, in heating at elevated temperature above some level, a phenomenon, referred to as flash evaporation, in which the host material and the dopant material are evaporated with a ratio between both materials kept substantially constant, can be utilized. In the present invention, since not only a time of light-irradiation and intensity of light-irradiation but also the number of transfers can be controlled, it is relatively easy to find out the conditions of moderate high-speed evaporation pursuant to flash evaporation while suppressing material degradation. Accordingly,transfer in which a ratio between the host material and the dopant material does not change before and after transferring, can be attained.

It is also possible to transfer the transferring material 37 from one donor substrate 30 to two device substrates 20, for example, an about half of the film thickness of the transferring material 37 is transferred to a device substrate by the first light-irradiation and the remaining about half is transferred to another device substrate by the second light-irradiation. If a film thickness of the transferring material to be transferred to each device substrate is adjusted, it is also possible to transfer the transferring material from one donor substrate to three or more device substrates.

In the arrangement of light-irradiation shown in Fig. 6(c), even if a position of the light-irradiation is displaced by δ as shown in Fig. 6(d), the fact remains that a full width of the transferring material 37 and apart of the width of the division pattern 34 are simultaneously heated, a similar uniform transferred layer 27 can be obtained. In the conventional method shown in Fig. 4(b), if a position of light-irradiation is displaced, the uniformity of the transferred layer 27 was extremely impaired. In the development of the large size organic EL display, in consideration of difficulties of positioning the light-irradiation with high accuracy over the entire area of the substrate, the burden of a light-irradiation apparatus is significantly reduced in accordance with the method of the present invention.

Fig. 7 is a sectional view showing an example of the method of light-irradiation to the donor substrate in the case where two or more types of different transferring materials 37 (three types of 37R, 37G and 37B in this example) exist corresponding to the division pattern 34. Here, different transferring materials means the case where materials differ, the case where the proportions of a plurality of materials are different, or the case where materials are the same, but film thicknesses or purities are the same. In accordance with this arrangement, the donor substrate 30, which, conventionally, required 3 sheets for every transferring material, requires only one sheet, and an operation to oppose the donor substrate 30 to the transferring substrate 20 requires only one action. In the case of three types of different transferring materials, the transferring materials can be irradiated with light and transferred for every types (only 37G in this example). In this time, for example, when light-irradiation of the transferring materials is performed by scanning at a low speed with light of relatively weak intensity in order to reduce damages to the transferring material 37G, a part of the adjoining transferring material 37R or 37B may be evaporated due to thermal diffusion in a lateral direction. But, since these evaporated materials are going to be evaporated late and are similar to ideas of the transfer in multiple steps shown in Fig. 6(b) or 6(c) in terms of results and do not matter. Moreover, since the division pattern 34 exist, there is not a possibility that a mixture of the transferring materials 37R and 37G adjacent to each other is formed as the transferred layer 27G, for example, as shown in Fig. 5.

As seen often in display applications, when a set of the transferring materials 37R, 37G and 37B formed is repeated k times in an x-direction of a sequence of 37R, 37G and 37B and h times in a y-direction perpendicular to the sequence, for example, a transfer time can be shortened by a factor of about m by scanning with light in the y-direction while irradiating m (m is a plus of 2 or more and k or less) transferring materials 37G simultaneously with light. Also in this case, if the light-to-heat conversion layer is irradiated with light so that the transferring materials 37G and a part of the division pattern 34 are simultaneously heated, the transferring materials 37 are less prone to being affected by displacements of light-irradiation represented by a displace δ shown in Fig. 6(d) and the effects similar to those shown in Fig. 6 (d) can be achieved.

Fig. 8 is a view showing one of preferable aspects of the present invention in which two or more types of different transferring materials 37 (three types of 37R, 37G and 37B in this example) are transferred by one operation by irradiating a light-to-heat conversion layer 33 with a light bundle, a width of which is wider than a total width of widths of two or more types of different transferring materials 37 (three types of 37R, 37G and 37B in this example) and a width of the division pattern 34 (widths of two of division patterns sandwiched between 37R and 37G and between 37G and 37B in this example). Herein, a case where a set of the 37R, 37G and 37B is transferred by one operation is shown as with the cases shown in Figs. 2 and 3, but as seen often in display applications, when a set of the transferring materials 37R, 37G and 37B formed is repeated k times in an x-direction of a sequence of 37R, 37G and 37B and h times in a y-direction perpendicular to the sequence, for example, a transfer time can be shortened by a factor of about m by scanning with light in the y-direction while irradiating m (m is an integer of 2 or more and k or less) sets of the transferring materials 37R, 37G and 37B simultaneously with light.

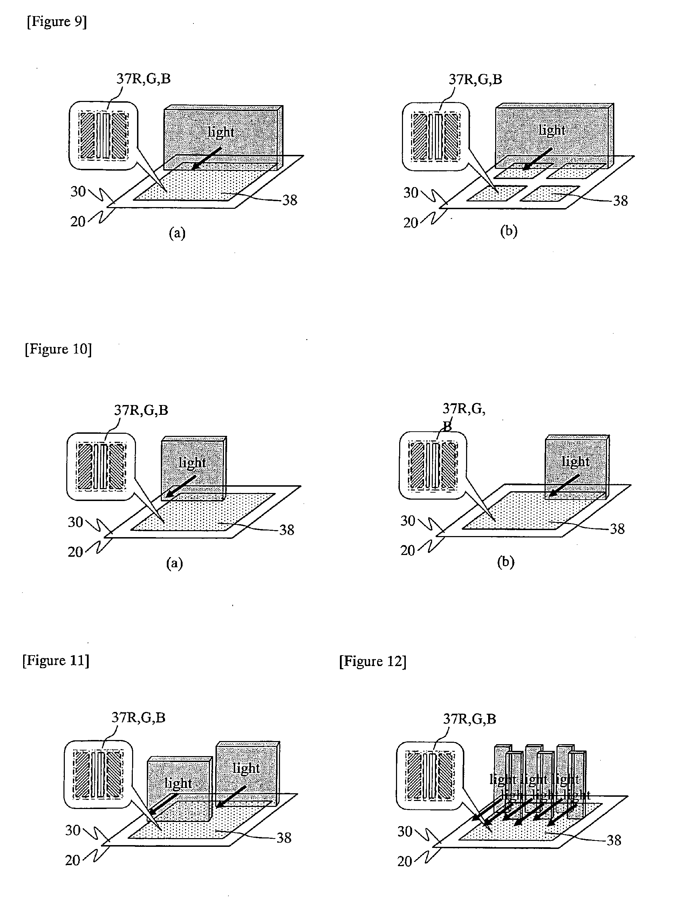

In the case of m = k, as shown in Fig. 9(a), by irradiating the transferring material with light to cover a full width of a transfer region 38 of the donor substrate 30, the whole transferring material can also be transferred by one operation through scanning once. In this arrangement, alignment of light-irradiation with the donor substrate 30 can be significantly reduced. When a plurality of transfer regions 38 exist on the substrate as shown in Fig. 9(b), these can be transferred by one operation. Even when the R, G, and B subpixels are not aligned with one another, as referred to as a delta arrangement, the transferring material can be easily transferred since irradiation light can be linearly scanned.

In the case of m < k, as shown in Fig. 10(a), for example, by irradiating a transfer region 38 with light to cover a half width of the transfer region 38 of the donor substrate 30, and by irradiating the remaining half of transfer region with the light in the next scanning as shown in Fig. 10(b), the whole transferring material can be transferred through two scannings (the case of m ≈ k/2). Furthermore, as shown in Fig. 11, by scanning simultaneously with two light bundles which are in two rows in a staggered configuration in a scanning direction, the antecedent transferring material layer 37 can also be transferred as with the above two scanning. Even when it is difficult to obtain one light to cover a full width of the transfer region 38 from the restriction of a maximum output or uniformity of light of a light source, by thus doing, the whole transferring material can be transferred by one operation similarly to pseudo one scanning (m = k). Naturally, by further narrowing a width of light and increasing the number of light bundles as shown in Fig. 12, a similar effect can be achieved.

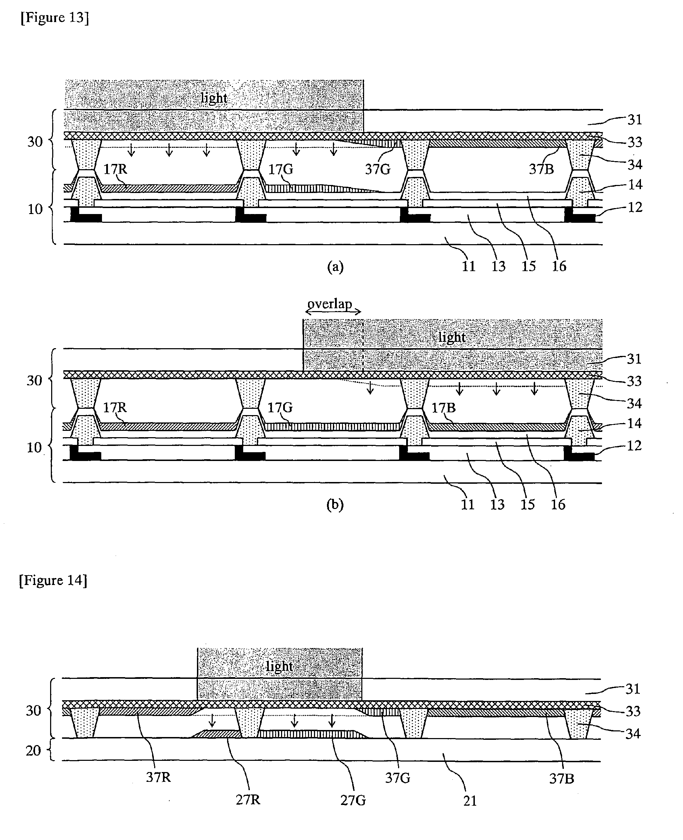

It is possible to overlap a plurality of light as shown Fig. 13. It is only necessary to irradiate the entire transfer region with light ultimately, and it is possible to select the optimal condition from various conditions of transferring such as a width of irradiation light bundle, an order of light-irradiation and a degree of overlap. Among others, it is preferred to overlap light at a position of a specific transferring material layer of the transferring material of two or more types of transferring material layer 37. As schematically shown in Fig. 13, a temperature gradient is inevitably produced at a boundary position of light and an influence of the temperature gradient varies depending on the type of the transferring material layer 37. When the light bundles overlap one another at random position, two or more types of transferred layers 17 having different uneven states are produced and therefore it become difficult to control these transferred layers simultaneously. On the other hand, if the influence of a temperature gradient is limited to a specific transferred layer, since a transferring material layer where unevenness hardly occur can be selected and further the conditions of light-irradiation to minimize the unevenness can be selected, it becomes possible to minimize the influence.

A method of selecting the specific transferring material layer is not particularly limited. The specific transferring material layer, for example, a layer having the lowest (or the highest) transferring temperature, a layer having the highest (or the lowest) decomposing temperature, or a layer having the smallest (or largest) thickness among the transferring material layers 37, may be selected in accordance with the object so that the unevenness is minimized in a device ultimately obtained.

When each of two or more type of different transferring materials comprises a mixture of two or more materials such as a host material and a dopant material, it is preferred to overlap one another at a position of the transferring material layer 37 (for example, 37G) of transferring material of a combination in which a difference in sublimation temperature between the above-mentioned two or more materials is the smallest. In the area of the organic EL device, it is known that a composition ratio of a host material and a dopant material has a large effect on light emission performance, and in accordance with the above method, the rate of change of the composition ratio of the transferred layer 17 due to a temperature gradient at a position of overlap can be minimized to suppress the occurrence of unevenness in the transferred layer 17 and thereby good light emission characteristics can be maintained.

Further, when a transferring material consisting of one type of material is contained in two or more types of different transferring materials, it is preferred to overlap light at a position of the transferring material layer 37 of the transferring material consisting of one type of a material. In this case, since there is no need to consider the change of the composition ratio in this transferring material layer, the influence of a temperature gradient at a position of overlap is extremely small.

In the above example of transferring by one operation, when the transferring materials 37R, 37G, and 37B have different evaporation temperatures (temperature dependency of a vapor pressure), the transferring by one operation may be performed by one light-irradiation in accordance with the transferring material having the highest evaporation temperature. On the contrary, for example, when the transferring materials 37R has the lowest evaporation temperature, all of the transferring materials 37R, and a part of the transferring material 37G and a part of the transferring material 37B may be transferred by one light-irradiation, and the rests of the transferring materials 37G and 37B may be transferred by next light-irradiation. Moreover, the transferring may be divided into three or more. Since a transfer time can be shortened by a factor of about m, it becomes possible to further reduce the damages to the transferring material 37 by dividing the transferring into m steps with the same expenditure of time. In consideration of the time which can be spent on a transfer process and damages to the transferring material, the optimal conditions can be selected from various conditions of transferring.

Fig. 14 shows another example of transferring by one operation of the present invention. A part of a transferring material 37R and a part of a transferring material 37G are transferred by one operation by irradiating a light-to-heat conversion layer so as to be extending over the transferring material 37R and the transferring material 37G with a light which is the same as that shown in Fig. 7 and has a width corresponding to a total width of a width of a transferring material 37G and a width of a division pattern 34. By repeating this transferring method a number of times while shifting a position of next irradiation light by a width of the antecedent irradiation light, transferring of the whole transferring materials 37R, 37G, and 37B is ultimately completed. In this method, there is no need to exactly control a positional relation between the irradiation light and the donor substrate. Furthermore, there is no need to shift a position of next irradiation light exactly by a width of the antecedent irradiation light, the next irradiation light may overlap the antecedent irradiation light. It is only necessary to irradiate the entire transfer region with light ultimately, and a width of irradiation light, an order of light-irradiation, and a degree of overlap are not particularly limited. Also in the above-mentioned delta arrangement, scanning can be performed linearly.

A large effect of the transferring by one operation is, as described previously, that it becomes unnecessary to control a position of light-irradiation as precisely as a conventional method controls. For example, when light is irradiated from a light source placed in the atmosphere to a donor substrate 30 placed in a vacuum, in the conventional method, since a little change in optical path, which is brought about by a transparent window separating the atmosphere and the vacuum, cannot be neglected, all of the light source and a light scanning mechanism need to be placed in a vacuum, and therefore, there is a problem of placing a large burden on equipment. On the other hand, in accordance with the method of the present invention, since changes in the optical path can be neglected, not only the light-irradiation apparatus but also a mechanism of the entire transfer process apparatus can be simplified.

Further, the transfer by one operation has another effect. In an irradiation range of a wide light bundle, thermal diffusion in a lateral direction, which becomes a problem in laser transfer, does not occur, and therefore it is possible to irradiate the transferring material for a relatively long time with light by scanning at a relatively low speed with laser. Thus, the control of the highest achieving temperature of the transferringmaterial becomes easier and patterning can be performed with high accuracy without damaging to the transferring material in transferring, and therefore degradation in device performance can be minimized. Further, since the reduction in damages to the transferring material leads to the reduction in damages to the division pattern, even the division pattern formed of organic materials hardly causes degradation. As a result, the donor substrate can be reused plural times, leading to a reduction in the cost of patterning.

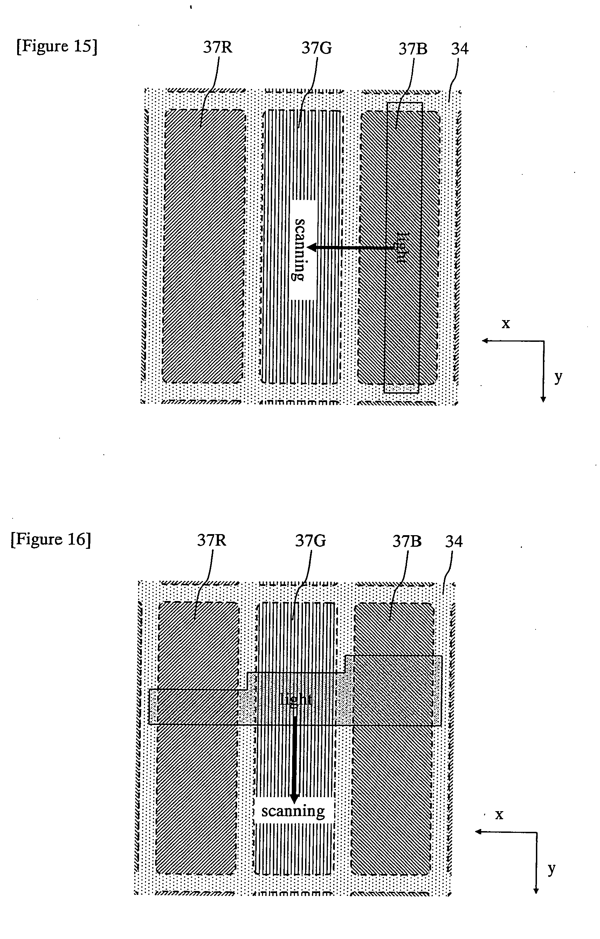

In the above description, an example in which scanning is performed in a y-direction with a rectangular light has, been described, but as shown in Fig. 15, scanning can also be performed in an x-direction of the sequence of the transferring materials 37R, 37G and 37B. Further, a scanning speed or light intensity does not have to be constant, and in the scanning in x-direction, and the scanning speed or the light intensity can be modulated, for example, so as to be most suitable for each evaporation temperature of the transferring materials 37R, 37G and 37B. It is preferable that a direction of scanning is along the division pattern 34 in an x-direction or a y-direction, but the direction is not particularly limited and a slant direction may be used.

A scanning speed is not particularly limited, but a range of 0.01 to 2 m/s is commonly preferably employed. When irradiation intensity of light is relatively low and it is intended to reduce the damages to the transferring material by scanning at a low speed, the scanning speed is preferably 0.6 m/s or less, and more preferably 0.3 m/s or less. When overall temperature is lowered by increasing the number of diving steps like the above-mentioned transfer in multiple steps, a scanning speed is preferably 0.3 m/s or more, which is relatively high-speed, in order to reduce an amount of charged heat per scanning.

As a light source of irradiation light, laser which easily achieves high intensity and is excellent in control of configuration of an irradiation light can be exemplified as a preferable light source, but light sources such as an infrared lamp, a tungsten lamp, a halogen lamp, a xenon lamp, and a flash lamp can also be used. As a laser light source, publicly known lasers such as semiconductor laser, fiber laser, YAG laser, argon ion laser, nitrogen laser, and excimer laser can be used. Since it is one of objects of the present invention to reduce damages to the transferring material, a continuous wave mode (CW) laser is more preferable than intermittent wave mode (pulse) laser in which light of high intensity is emitted in a short time.

A wavelength of irradiation light is not particularly limited as long as absorption in an irradiation atmosphere and the support of the donor substrate is small and the light-to-heat conversion layer absorbs the laser with efficiency. Therefore, not only lasers in visible light region, but also lasers in ultra violet light to laser in infrared light can be used. In consideration of a material of a favorable support of the donor substrate, a preferred wavelength region is 300 nm to 5 µm, and a more preferred wavelength region is 380 nm to 2 µm.

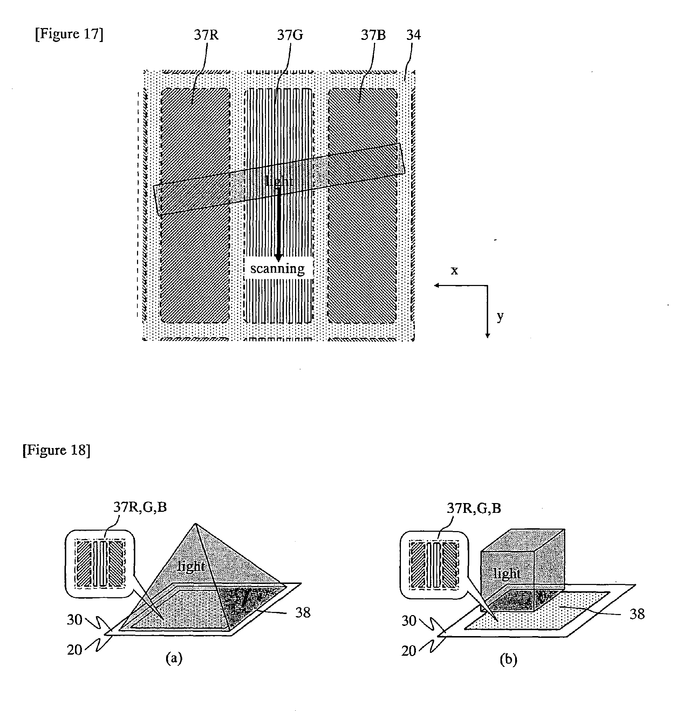

A configuration of the irradiation light is not limited to a rectangle. An optimal configuration, for example, rod-like, an ellipse, a square, a polygon, can be selected in accordance with the conditions of transferring. The irradiation light may be formed by superimposing lights from a plurality of light sources, or on the contrary, light from a single light source can be split into a plurality of irradiation light. As shown in Fig. 16, by scanning with a light having a width varying stepwise in a direction of scanning, it is possible to carry out the transfer by one operation in which an irradiation time (heating time) for each of the transferring materials 37R, 37G and 37B is adjusted to make the conditions of transferring most suitable for each evaporation temperature of the transferring materials 37R, 37G and 37B. By modulating a width of the light in a scanning direction in accordance with the unevenness of intensity of the irradiation light, a density of irradiation energy (irradiation intensity x irradiation time) can be kept constant. Further, as shown in Fig. 17, a rectangular light may be slantwise arranged and scanning may be carried out in a y-direction with this light. When a configuration (width) of the irradiation light is fixed, this method is adaptable the transfer having various pitches without having to significantly change an optical system.

As shown in Fig. 18(a), the transferring material can also be irradiated with light to cover a full region of a transfer region 38 of the donor substrate 30. In this case, the whole transferringmaterial can be transferred by one operation without scanning with irradiation light. Moreover, stepwise irradiation, in which a transfer region 38 is irradiated with light to partially cover the transfer region 38 of the donor substrate 30 as shown in Fig. 18(b) and next an unirradiated portion is irradiated, may be employed. Also in this case, optical paths of irradiation lights may overlap with each other, alignment of light-irradiation with each other can be significantly facilitated.

Preferable ranges of irradiation intensity and a heating temperature of the transferring material are affected by various conditions such as uniformity of irradiation light, an irradiation time (scanning speed), materials and thicknesses of the support of the donor substrate and the light-to-heat conversion layer, a reflection factor, a material and a shape of the division pattern, and a material and a thickness of the transferring material. In the present invention, it is an index to arrange the irradiation conditions such that an energy density absorbed by the light-to-heat conversion layer is 0.01 to 10 J/cm² and the transferring material is heated to 220 to 400°C.

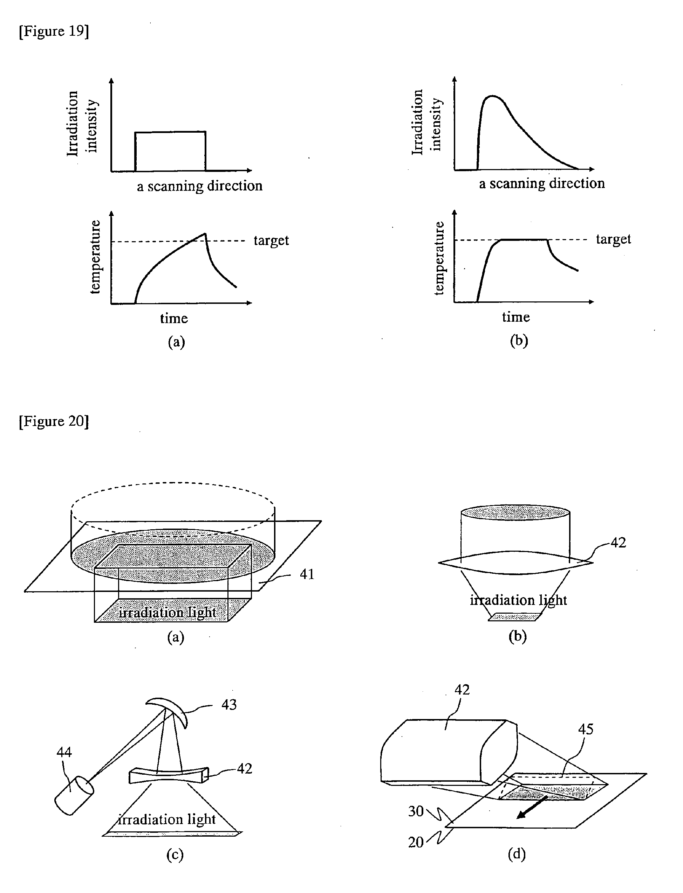

Fig. 19 is a conceptual drawing showing changes in temperature of the transferring material (or the light-to-heat conversion layer) in scanning/irradiating the transferring material with light. Since this change depends on various conditions and, cannot say briefly, as shown in Fig. 19(a), under the condition of constant irradiation intensity, temperature increase gradually and tends to increase after reaching a target (evaporation temperature). Under this condition, in some of the thickness and heat resistance of the transferring material and the irradiation time, transfer can be carried out without difficulty. On the other hand, there is an example in which as a preferable irradiation method for reducing damages to transferring material, as shown in Fig. 19 (b), using light having distributed intensity so that a temperature becomes constant in the vicinity of the target and a constant time is lengthened, irradiation intensity at some point is changed with time. Since the reduction in damages to the transferring material means the reduction in damages to the division pattern, for example, even when the division pattern is formed of photosensitive organic materials, the division pattern is not degraded and the number of reuses of the donor substrate can be increased. As shown in Fig. 18, when the transferring material is irradiated with irradiation light to cover a certain area without scanning, similar effects can be achieved by reading "a scanning direction" in Fig. 19 as "an irradiation time".

Fig. 20 is a perspective view showing a method for forming irradiation light into a shape. As shown in Fig. 20(a), a rectangular irradiation light bundle can be cut out from a circular light bundle with an optical mask 41. A knife edge or an optical interference pattern may be used in addition to the optical mask 41. As shown in Figs. 20(b) and 20(c), the irradiation light bundle can be shaped by collecting or expanding light from a light source 44 with a lens 42 or a mirror 43. Further, by appropriately combining the photomask 41, the lens 42, and the mirror 43, light can be shaped into an irradiation light bundle having any configuration. For example, it is also possible to design in such a way that irradiation intensity is uniform in a direction of amajor axis of a rectangular irradiation light bundle and has a Gaussian distribution in a direction of a minor axis.

Fig. 20 (d) shows an example to realize the time dependency of irradiation intensity described in Fig. 19(b). The irradiation light is collected in a slanting direction to the donor substrate 30 through the lens 42. If the irradiation light is arranged so that a front side of a virtual focus-plane 45 indicated by a broken line approximately agrees with a light-to-heat conversion layer (not shown) of the donor substrate 30, since the front side becomes on-focus condition consistent with a focal distance of the lens 42, an irradiation density is maximized, and since the back side becomes off-focus condition out of a focal distance of the lens 42, light is blurred and therefore an irradiation density is reduced. If scanning is carried out with light toward the front side from the back side by use of such arrangement, the time dependency of irradiation intensity, conceptually shown in Fig. 19(b), can be yield.

### (2) Donor substrate

The support of the donor substrate is not particularly limited as long as it has a low absorptance and is composed of a material on which the light-to-heat conversion layer, the division pattern, and the transferring material can be stably formed. A resin film can be used depending on the condition. Examples of the resin material include polyester, polyethylene, polyethylene terephthalate, polyethylene naphthalate, polycarbonate, polyacryl, polysulfone, polyethersulfone, polyphenylene sulfide, polyimide, polyamide, polybenzooxazole, polyepoxy, polypropylene, polyolefin, aramide resin, and silicon resin.

As support which is preferable in terms of chemical and thermal stability, dimensional stability, mechanical strength, and transparency, a glass plate can be exemplified. The glass plate can be selected from soda lime glass, alkali-free glass, lead glass, borosilicate glass, aluminosilicate glass, low-expansion glass, and quartz glass. When the transfer process is performed in a vacuum, since it is required that gas emitted from the support is less, glass is a particularly preferable support.

Even if the light-to-heat conversion layer is heated to elevated temperature, it is necessary to keep an increase in temperature (thermal expansion) of the support itself within an allowable range, and therefore it is preferred that a heat capacity of the support is adequately larger than that of the light-to-heat conversion layer. Therefore, the thickness of the support is preferably 10 times larger than that of the light-to-heat conversion layer. The allowable range cannot be shown because it depends on a size of the transfer region or required accuracy of patterning. However, for example, when a temperature of the light-to-heat conversion layer increases from room temperature to 300ºC and by its thermal diffusion, the support is heated and an increase in temperature of the support itself is suppressed to 3ºC or less, which is one-hundredth of a temperature increase of the light-to-heat conversion layer, the thickness of the support is preferably 100 times or more larger than that of the light-to-heat conversion layer in the case where a volumetric heat capacity of the light-to-heat conversion layer is about equal to that of the support. When an increase in temperature of the support itself is suppressed to 1ºC or less, which is one-three hundredth of a temperature increase of the light-to-heat conversion layer, the thickness of the support is further preferably 300 times or more larger than that of the light-to-heat conversion layer. In the typical case where a volumetric heat capacity of the light-to-heat conversion layer is about 2 times larger than that of the support, the thickness of the support is preferably 200 times or more larger than that of the light-to-heat conversion layer, and more preferably 600 times or more. By doing thus, even when the device increases in size, an amount of displacement of dimension is less and highly accurate patterning becomes possible.

The light-to-heat conversion layer is not particularly limited as long as it absorbs light and emits heat with efficiency and its material is stable for the heat generated. For example, thin films formed by dispersing carbon black, graphite, titanium black, organic pigment or metal particle in a resin, or inorganic thin films such as metal thin films and the like can be used. Since in the present invention, the light-to-heat conversion layer can be heated to about 300ºC, the light-to-heat conversion layer is preferably composed of an inorganic thin film having high heat resistance, and particularly preferably composed of a metal thin film from viewpoints of light absorption and a film forming property. As a metal material, a simple metal such as tungsten, tantalum, molybdenum, titanium, chromium, gold, silver, copper, platinum, iron, zinc, aluminum, cobalt, nickel, magnesium, vanadium, zirconium, silicon, and carbon, and thin films of alloy thereof, and laminated thin films of thereof can be used.

An anti-reflection layer may be formed on the support side of the light-to-heat conversion layer as required. Furthermore, the anti-reflection layer may be also formed on the surface of light-entering side of the support. An optical interference thin film using a difference of refractive index is suitably used for these anti-reflection layers. Thin films of simple substance such as silicon, silicon oxide, silicon nitride, zinc oxide, magnesium oxide, and titanium oxide, thin films of mixture thereof, or laminated thin films of thereof can be used.

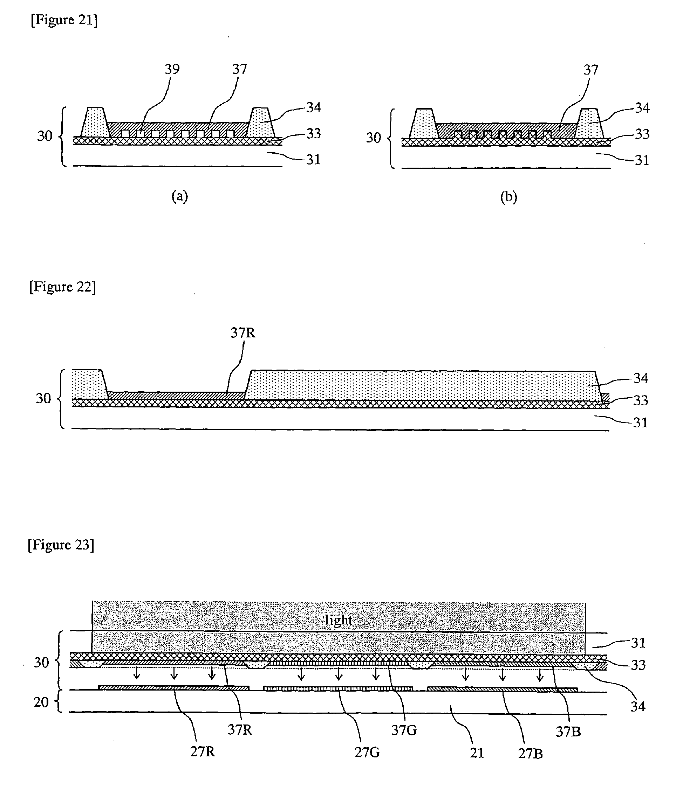

A transfer assist layer may be formed on the transferring material side of the light-to-heat conversion layer as required. One of functions of the transfer assist layer is a function of preventing the degradation of the transferring material due to a catalytic effect of the heated light-to-heat conversion layer, and an inactive inorganic thin film such as tungsten, tantalum, molybdenum, silicon or oxide/nitride can be used. Another function of the transfer assist layer is a surface modification function in forming a film of the transferring material by application process, and rough surface thin film of the exemplified inactive inorganic thin film, or porous film of metal oxide can be used. Another function of the transfer assist layer is to equalize heating of the transferring material, for example, as shown in Fig. 21(a), in order to heat the transferring material 37 having a relatively large thickness uniformly, a transfer assist layer 39 having a spike-shaped (or porous) structure is formed of metal having excellent thermal conductivity and the transferring material 37 is arranged so as to support the gaps between the spike. The transfer assist layer having this function, as shown in Fig. 21(b), may be unified with the light-to-heat conversion layer 37.

Since the light-to-heat conversion layer need to provide sufficient heat for evaporation of the transferring material, it is preferred that a heat capacity of the light-to-heat conversion layer is larger than that of the transferring material. Therefore, it is preferred that a thickness of the light-to-heat conversion layer is larger than that of the transferring material, and 5 times or more larger than that of the transferring material. Specifically, the thickness is preferably 0.02 to 2 µm, and more preferably 0.1 to 1 µm. Since the light-to-heat conversion layer preferably absorbs preferably 90% or more of the irradiation light and more preferably 95% or more of the irradiation light, it is preferred to design the thickness of the light-to-heat conversion layer so as to satisfy these conditions. When the transfer assist layer is formed, it is preferred to design the transfer assist layer having a small film thickness within a range of satisfying the required function so that heat generated in the light-to-heat conversion layer is transferred to the transferring material with efficiency without being interfered with by the transfer assist layer.

A planar shape of the light-to-heat conversion layer is not particularly limited as long as the light-to-heat conversion layer is formed at an area where the transferring material exists. As exemplified above, the light-to-heat conversion layer may be formed over the entire area of the donor substrate, or for example when adhesion of the division pattern to the support is high but that to the light-to-heat conversion layer is poor, the light-to-heat conversion layer may be patterned in such a way that the light-to-heat conversion layer is discontinuous at the bottom of the division pattern and the division pattern is brought into contact with at least a part of the support. When the light-to-heat conversion layer is patterned, its pattern needs not to have the same configuration as that of the division pattern. For example, when the division pattern is lattice-like, the light-to-heat conversion layer may be stripe-like. Since the light-to-heat conversion layer has a large absorptance of light, it is preferred to form a position mark of the donor substrate at an appropriate location inside or outside of the transfer region using the light-to-heat conversion layer.

A method for forming the light-to-heat conversion layer or the transfer assist layer, publicly known technologies such as spin coating, slit coating, vacuum deposition, electron beam (EB) evaporation, sputtering, and ion plating can be used in accordance with the materials. In the case of patterning, a publicly known photolithographic process or a laser ablation process can be used.

The division pattern is not particularly limited as long as it defines a boundary of the transferring material and its material and constitution are stable for the heat generated in the light-to-heat conversion layer. Examples of the inorganic materials include oxides/nitrides including silicon oxide and silicon nitride, glass, ceramic and the like, and examples of the organic materials include resins such as polyvinyl, polyimide, polybenzooxazole, polystyrene, acryl, novolac, silicone and the like. Glass paste material, which is used for a bank of plasma TV set, can also be used for the division pattern of the present invention. The thermal conductivity of the division pattern is not particularly limited, but a material of lower thermal conductivity like organic substances is preferable from the viewpoint of preventing heat from diffusing to the opposite device substrate through the division pattern. Moreover, examples of the material which are superior in patterning characteristics and heat resistance include polyimide and polybenzoxazole.

A film formation method of the division pattern is not particularly limited, and when an inorganic substance is used, publicly known technologies such as vacuum deposition, electron beam (EB) evaporation, sputtering, ion plating, CVD and laser ablation can be used, and when an organic substance is used, publicly known technologies such as spin coating, slit coating and dip coating can be used. A method for patterning the division pattern is not particularly limited, and for example, a publicly known photolithographic process can be used. The division pattern may be patterned by an etching (or lift off) process using a photoresist, or by using a material obtained by providing photosensitivity for the exemplified resin material, the division pattern may be directly exposed/developed to pattern. Furthermore, stamping or imprinting in which a die is pressed against the division pattern formed over the entire area, ink- jet printing or nozzle printing in which a resin material is directly formed into a pattern, or various printing methods can also be used.

A shape of the division pattern is not limited to a lattice-like structure previously described, and for example, when three types of transferring materials 37R, 37G and 37B are formed on the donor substrate 30, a planar shape of the division pattern 34 may be a stripe extending in the y-direction. Further, as shown in Fig. 22, the division pattern 34 wider than the transferring material 37 may be formed. In this case, the transferring materials 37R, 37G and 37B can be patterned on one device substrate by repeating the process step three times, in which three donor substrates 30, on which three types of transferring materials 37R, 37G and 37B are respectively formed, are prepared, and the three donor substrates 30 are opposed to one device substrate and transferred according to the present invention. This case is an example of a configuration which is effective in highly precise patterning requiring reductions in pitches or gaps of the transferring materials 37R, 37G and 37B.

A thickness of the division pattern is not particularly limited. For example, as shown in Fig. 23, when the division pattern 34 has the same thickness as that of the transferring material 37, the transferring materials 37R, 37G and 37B can be transferred without being mixed with one another, and even when the division pattern 34 has a smaller thickness than the transferring material 37, the transferring materials 37R, 37G and 37B can be transferred similarly because if the gap between the donor substrate 30 and the device substrate 20 is held, a transferring material evaporated during transfer is just slightly spread and deposited. It is preferred that the transferring material does not contact directly with a surface on which the transferring material is transferred. Further, since a distance between the transferring material of the donor substrate and the surface of the device substrate on which the transferring material is transferred is held preferably at 1 to 100 µm, and more preferably at 2 to 20 µm, the thickness of the division pattern is preferably larger than that of the transferring material 37, and preferably 1 to 100 µm, and more preferably 2 to 20 µm. By opposing the division pattern having such a thickness to the device substrate, the distance between the transferring material of the donor substrate and the surface of the device substrate is easily held at a constant value and a possibility that an evaporated transferring material penetrates into another transferring region can be reduced.

The cross-sectional profile of the division pattern is preferably a forward tapered shape in order to facilitate uniform deposition of the evaporated transferring material on the device substrate. As shown in Fig. 2, when a pattern like the insulating layer 14 exists on the device substrate 10, a width of the insulating layer 14 is preferably larger than that of the division pattern 34. Further, in alignment, the respective substrates are preferably arranged so that the width of the division pattern 34 falls within the width of the insulating layer 14. In this case, even when the thickness of the division pattern 34 is small, the donor substrate 30 and the device substrate 10 can be held at a desired distance by increasing the thickness of the insulating layer 14. A typical width of a bank of the division pattern is 5 to 50 µm and a typical pitch is 25 to 300 µm but these are not particularly limited and may be designed so as to be optimal values in accordance with their use.

When an application method described later is used in arranging the transferring material within the division pattern, a top surface of the division pattern may be subjected to a liquid repellency treatment (control of surface energy) in order to prevent a solution from mixing in another transferring region or from riding on the top surface of the division pattern. Examples of the liquid repellency treatment include a method of mixing a liquid repellent material such as a fluorine-based material with the resin material composing the division pattern and a method of selectively forming a region containing the liquid repellent material in high concentration at the surface or the top surface of the division pattern. In addition, there are methods using a publicly known technology, for example, a method in which the structure of the division pattern is amultiple-layer structure of materials having different surface energy, and a method in which after forming the division pattern, the division pattern is subjected to light-irradiation, plasma treatment by fluorine-based material-containing gas or UV-ozone treatment to control a surface energy state.

### (3) Transferring substrate

The transferringmaterials are materials to form thin films composing devices such as organic EL devices, organic TFTs, photoelectric conversion devices, various sensors and the like. The transferring material may be any of organic materials and inorganic materials including metal, and may be a material which is transferred from a donor substrate to a device substrate by evaporating, sublimating or ablating through sublimation, or by using changes in adhesion or changes in volume when the material is heated. Further, the transferring material may be a material which is a precursor of a thin film to be formed and is converted to a material to form thin films by heat or light before or during transfer to form a transferred layer.

The thickness of the transferring material varies depending on its functions or the number of transfers. For example, in the case where a donor material (electron injection material) such as lithium fluoride is transferred, 1 nm is enough for the thickness of the material, and in the case where an electrode material is transferred, the thickness of the material may be 100 nm or more. In the case of the emissive layer which is a favorable patterned thin film of the present invention, the thickness of the transferring material is preferably 10 to 100 nm and more preferably 20 to 50 nm.

A method for forming the transferring material is not particularly limited and a dry process such as a vacuum deposition process or a sputtering process can be employed, but as a method which is compatible for large size devices, a process, in which a solution containing at least a transferring material and a solvent is applied within a division pattern, the solvent is evaporated, and then the transferring material is transferred, is preferable. Examples of the application include various printing processes such as ink-jet, nozzle application, electrolytic polymerization and electrodeposition, offset and flexography, planography, relief, gravure, and screen printing. Particularly, in the present invention, it is important to exactly form a constant amount of transferring material within each division pattern, and in point of this, an ink-jet method can be exemplified as a particularly preferred example.

If the division pattern does not exist, the RGB organic EL material layers formed of a coating solution contact with one another and a boundary between the organic EL material layers is not uniform and not a few mixed layers are formed. When the organic EL material layers are formed with the EL material layers spaced to prevent the contact of the layer with another and the formation of mixed layer, it is difficult to equalize the thickness of a boundary region with that of a central portion. In any cases, since this boundary region causes deterioration of device performance, it cannot be transferred, and therefore it is necessary to selectively transfer a region which is narrower than a pattern of the organic EL material on the donor substrate. Accordingly, a width of the actually usable organic EL material becomes narrow and if an organic EL display is produced by use of this, an aperture ratio of a pixel is low (an area of non-light emission region is large). Further, since the transferring material has to be transferred excluding the boundary region, the transferring material can not be transferred by one operation, and therefore the R transferring material, the G transferring material, and the B transferring material are irradiated in turn with laser to transfer these materials independently of each other and it becomes necessary to position the laser with high accuracy under laser irradiation of high intensity. From the viewpoint of solving such problems, a method, in which transferring is performed by one operation by the above-mentioned method by using the donor substrate having the division pattern and the transferring material formed of a coating solution, can be exemplified as a particularly preferable aspect of the present invention.

When a solution containing a transferring material and a solvent is applied to an application method, generally, a surfactant or a dispersant is often added to adjust viscosity, surface tension and dispersibility and ink is formed. However, in the present invention, it is concerned that if these additives exist in a transferring material as residuals, these additives can be taken into a transferred layer during transfer and can have a detrimental effect on the device performance as impurities. Therefore, it is preferred to minimize addition or unintended mixing of these impurities and it is preferred to prepare a solution in such a way that purity of the transferring material after drying is preferably 95% or more and more preferably 98% or more. By adjusting a ratio of the transferring material to 95% by weight or more with respect to the component other than a solvent in the ink, this preparation of the solution is possible.

As the solvent, publicly known materials such as water, alcohols, hydrocarbons, aromatic compounds, heterocyclic compounds, esters, ethers, and ketones can be used. In the ink-jet printing which is suitably used in the present invention, since a solvent having a relatively high boiling point of 100°C or higher, further 150°C or higher is used and the solubility of the organic EL material is high, N-methylpyrrolidone (NMP), dimethylimidazolidinone (DMI), γ-butyllactone (γBL), ethyl benzoate, tetrahydronaphthalene (THN), xylene, cumene and the like can be exemplified as suitable solvents.

When the transferring material satisfied all of solubility, transfer resistance, and device performance after transferring, it is preferred to dissolve an original form of the transferring material in a solvent. When the solubility of the transferring material is poor, the solubility of the transferring material can be improved by introducing a group, which is soluble in a solvent, such as an alkyl group into the transferring material. When a soluble group is introduced into the original form of the transferring material having excellent device performance, performance may be deteriorated. In that case, for example, the soluble group is detached by heat during transferring and the original form of the material is deposited on the device substrate.

In order to prevent gas from generating or prevent detached substances from being mixed into the transferred layer when the transferring material, in which the soluble group is introduced, is transferred, it is preferred that the transferring material has a group which is soluble in a solvent at the time of applying the transferring material, the soluble group is converted or detached by heat or light after applying the transferring material, and then the transferring material is transferred. For example, taking a material having a benzene ring or an anthracene ring as an example, it is possible to irradiate a material having a soluble group represented by the formulas (1) and (2) with light to convert it to an original form of the material. Further, it is possible to introduce a intramolecular crosslinked structure such as an ethylene group or a diketone group as a soluble group, as shown in the formulas (3) to (6), and to return to an original form of material by a process for detaching ethylene or carbon monoxide from the transferring material. Conversion or detachment of the soluble group may be performed in a solution state before drying, or may be performed in a solid state after drying, but in consideration of the stability of a process, it is preferably performed in a solid state after drying. Since an original form of molecule of the transferring material is often nonpolar, it is preferred that the detached substance has a small molecular weight and is polar (repellent to a nonpolar original form of molecule) for preventing the detached substances from remaining in the transferring material in detaching the soluble group in a solid state. Further, in order to eliminate oxygen and water adsorbed in the transferring material together with the detached substances, the detached substance preferably easily reacts with these molecules. From these viewpoints, it is particularly preferred to convert or detach the soluble group by a process for detaching carbon monoxide. This method is applicable for condensed polycyclic hydrocarbon compounds such as naphthacene, pyrene, and perylene; and condensed polycyclic hetero compounds. Naturally, these may be substituted, or may be substituted or unsubstituted.

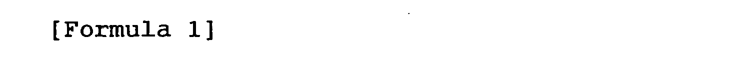

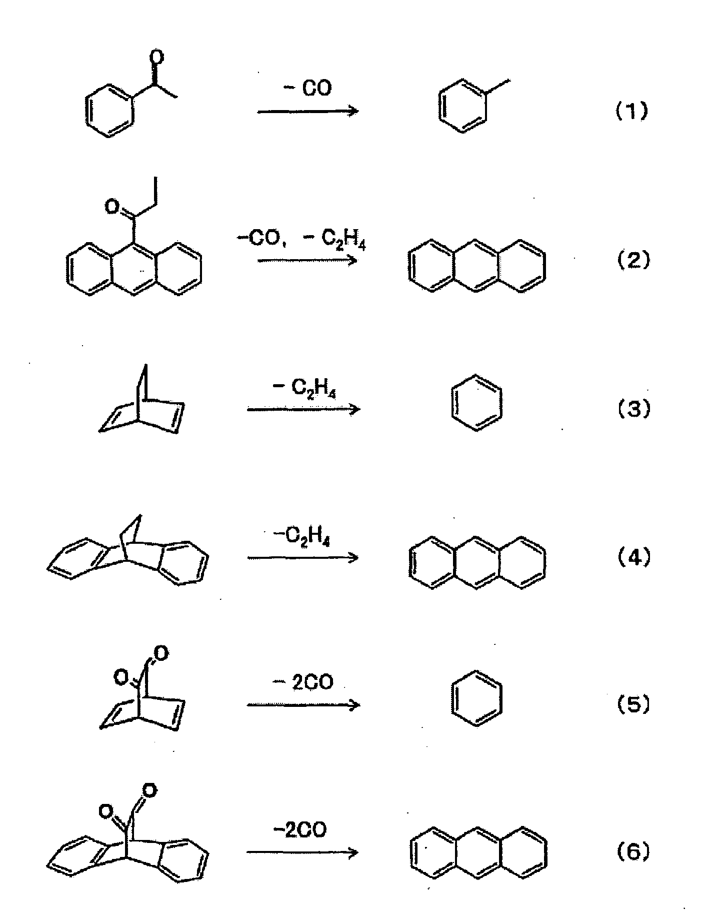

### (4) Device substrate

The support of the device substrate is not particularly limited and the material exemplified in the donor substrate can be used. In order to prevent the patterning accuracy from being deteriorated due to a difference in a coefficient of thermal expansion resulting from changes in temperature when both substrate are opposed to one another and the transferring material is transferred, a difference in coefficient of thermal expansion between the device substrate and the support of the donor substrate is preferably 10 ppm/°C or less and these substrates are more preferably made of the same material. The glass plate exemplified as a particularly preferable support of the donor substrate can also be exemplified as a particularly preferable support of the device substrate. In addition, thicknesses of both substrates maybe the same ormaybe different.

The device substrate may be composed of only the support at the time of transferring, but structures required to compose a device are commonly previously formed on the support. For example, in the organic EL device shown in Fig. 1, layers up to the insulating layer 14 or the hole transporting layer 16 are formed by the conventional technology, and this can be used as a device substrate.

The structure like the insulating layer is not essential, but it is preferred that the insulating layer is previously formed on the device substrate from the viewpoint of preventing the division pattern of the donor substrate from contacting with the underlayer formed on the device substrate to damage the underlayer when the donor substrate is opposed to the device substrate. The materials, the film formation methods or patterning methods which have been exemplified in the division pattern of the donor substrate can be used for the formation of the insulating layer. As a shape, a thickness, a width and a pitch of the insulating layer, the shapes or the values which have been exemplified in the division pattern of the donor substrate can also be used.

### (5) Transferring process

It is possible that the donor substrate is opposed to the device substrate in a vacuum, the opposed substrates are taken out to the atmosphere while holding a transfer space at a vacuum and transferring is performed. For example, the division pattern of the donor substrate and/or the insulating layer of the device substrate and a region surrounded by these substrates can be held at a vacuum. In this case, a vacuum seal function may be provided at a peripheral portion of the donor substrate and/or the device substrate. When an underlayer of the device substrate, for example hole transporting layer, is formed in a vacuum, the emissive layer is patterned in accordance with the present invention and the electron transporting layer is also formed by a vacuum process, it is preferred that the donor substrate is opposed to the device substrate in a vacuum and transferring is performed by a vacuum process. In this case, for a method for aligning the donor substrate with the device substrate with high accuracy in a vacuum and maintaining a state of being opposed, publicly known technologies, such as the steps of dispensing a liquid-crystal material in a vacuum and integrating which are used in a production process of a liquid crystal display, can be used. Further, irrespective of transferring atmosphere, the donor substrate may be left in the air to be cooled or may be cooled at the time of transferring, or when the donor substrate is reused, the donor substrate may also be used in the form of an endless belt. If a light-to-heat conversion layer formed of a conductor such as metal is used, the donor substrate can be easily held by an electrostatic system.

In the present invention, since transferring in a vapor deposition mode is preferred, it is preferred to pattern a single-layer transferred layer in one transfer. However, by using a peeling mode or an ablation mode, for example, a laminate structure of electron transporting layer/emissive layer is previously formed on the donor substrate and the laminate structure is transferred on the device substrate while maintaining the laminated state, and thereby a transferred layer of emissive layer/ electron transporting layer can be patterned by one transfer.

An atmosphere of transferring may be atmospheric or may be under a reduced pressure. For example, in the case of reactive transfer, transfer may be performed in the presence of active gas such as oxygen. In the present invention, since the reduction of transferring damages to the transferring material is one of the objects, it is preferred to carry out the transfer in the atmosphere of inert gas such as a nitrogen gas or to carry out the transfer in a vacuum. If a pressure is properly controlled, it is possible to accelerate leveling of the unevenness of film thickness at the time of transferring. It is particularly preferred to carry out the transfer in a vacuum from the viewpoint of reducing the damages to the transferring material and the mixing of impurities into the transferred layer and lowering an evaporation temperature.

Unevenness of film thickness was one of problems of the conventional methods which directly use a thin film formed by an application method as a functional layer of the organic EL device. Also, in the present invention, equivalent unevenness of film thickness can occur at the point of time when a transferring material is formed by an application method, but in a vapor deposition mode in the present invention, which is a preferable transfer process, since the transferring material is evaporated in a state of disentangling to a molecular (atomic) level and then deposited on the device substrate during transferring, the unevenness of film thickness of the transferred layer is reduced. Accordingly, for example, even when the transferring material is a grain consisting of molecular assembly like pigment and is not a continuous film on the donor substrate at the time of applying the transferring material, by disentangling the transferring material to a molecular level, evaporating and depositing the disentangled transferring material at the time of transferring , a transferred layer having excellent uniformity of film thickness can be attained on the device substrate.

Next, a method of producing a device by using the patterning method of the present invention will be described. In the present invention, the device refers to organic EL devices, organic TFTs, photoelectric conversion devices, various sensors and the like. An organic semiconductor layer, an insulating layer, and various electrodes such as a source electrode, a drain electrode and a gate electrode in the organic TFT; electrodes in the organic solar cell; and a sensing layer and an electrode in the sensor can be patterned in accordance with the present invention. Hereinafter, the production method of the organic EL device as an example will be described.

Fig. 1 is a sectional view showing an example of a typical structure of an organic EL device 10 (display). An active matrix circuit composed of a TFT 12 and a flattened layer 13 is configured on a support 11. A device portion is a first electrode 15/a hole transporting layer 16/an emissive layer 17/an electron transporting layer 18/a second electrode 19 formed on the active matrix circuit. An insulating layer 14, which prevents the occurrence of a short circuit at an electrode end and defines an emissive region, is formed at an end of the first electrode. The device configuration is not limited to this example and for example, only one layer of the emissive layer having both of a hole transporting function and an electron transporting function may be formed between the first electrode and the second electrode, and the hole transporting layer may have a layered structure of a hole injection layer and a hole transporting layer and an electron transporting layer may have a layered structure of an electron transporting layer and an electron injection layer. Further, when the emissive layer has an electron transporting function, the electron transporting layer may be omitted. Moreover, the device portion may be laminated in the order of a first electrode/an electron transporting layer/an emissive layer/a hole transporting layer/a second electrode. Further, these layers may be a single-layer or may be a multi-layer. In addition, after the formation of the second electrode, but not shown, a protective layer or a color filter may be formed or sealing may be performed by using a publicly known technology or the patterning method of the present invention.

In the color display, it is necessary to pattern at least the emissive layer and the emissive layer is a thin film suitably patterned in the present invention. The insulating layer, the first electrode, and a TFT are often patterned by a publicly known photolithographic process, but these may be patterned according to the present invention. Further, when at least one layer of the hole transporting layer, the electron transporting layer, or the second electrode needs to be patterned, this may be patterned according to the present invention. Further, only R, and G emissive layers among R, G, and B emissive layers are patterned according to the present invention and thereon, a layer serving as both of B emissive layer and R, and G electron transporting layers may be formed over the entire area.

With respect to a preparation example of the organic EL device shown in Fig. 1, layers up to the first electrode 15 are patterned by a publicly known technique using a photolithographic process, the insulating layer 14 is patterned by a publicly known technique using a photosensitive polyimide precursor material and then the hole transporting layer 16 is formed over the entire area by a publicly known technique using a vacuum deposition process. The emissive layers 17R, 17G and 17B are patterned on the hole transporting layer 16 as an underlayer by the present invention shown in Fig. 2. By forming the electron transporting layer 18 and the second electrode 19 over the entire area thereon by a publicly known technique using a vacuum deposition process, the organic EL device can be completed.

The emissive layer may be a single-layer or may be a multi-layer, and a material of each layer may be a single material or may be a mixture of a plurality of materials. The emissive layer preferably has a single-layer structure of a mixture of a host material and a dopant material from the viewpoint of luminance efficiency, color purity and durability. Therefore, a transferring material to form a film of an emissive layer is preferably a mixture of a host material and a dopant material.

When an application method described later is used in arranging the transferring material with in the division pattern, a solution of the mixture of a host material and a dopant material can be applied and dried to form the transferring material. A solution of the host material and a solution of the dopant material may be applied separately. Even if the host material and the dopant material are not uniformly mixed with each other at a stage of forming a transferring material, both may be mixed with each other at the time of transferring. Further, a concentration of the dopant material in the emissive layer may be changed in a thickness direction at the time of transferring by use of the difference of evaporation temperature between the host material and the dopant material.

Examples of the emissive material include low molecular materials, for example, anthracene derivatives, naphthacene derivatives, pyrene derivatives, metal complexes such as quinolinol complexes such as tris (8-quinolinato) aluminum (Alq₃) and zinc(benzothiazolyl)phenol complex, bisstyrylanthracene derivatives, tetraphenylbutadiene derivatives, coumarin derivatives, oxadiazole derivatives, benzoxazole derivatives, carbazol derivatives, distyrylbenzene derivatives, pyrrolopyridine derivatives, perinone derivatives, cyclopentadiene derivatives, oxadiazole derivatives, thiadiazolo pyrizine derivatives, rubrene, quinacridone derivatives, phenoxazone derivatives, perinone derivatives, perylene derivatives, coumarin derivatives, crysene derivatives, pyrromethene derivatives, and iridium complex-based materials referred to as a phosphorescent material; and high molecular materials, for example, polyphenylene vinylene derivatives; poly(p-phenylene) derivatives; and polythiophene derivatives. Particularly, anthracene derivatives, naphthacene derivatives, pyrene derivatives, crysene derivatives, pyrromethene derivatives, and various phosphorescent materials can be exemplified as materials which are superior in light emitting performance and suitable for the patterning method of the present invention.

The hole transporting layer may be a single-layer or may be a multi-layer, and a material of each layer may be a single material or may be a mixture of a plurality of materials. The hole transporting layer also includes a layer referred to as a hole injection layer. An acceptor material, which promotes a hole transporting property, may be mixed in the hole transporting layer from the viewpoint of a hole transporting property (low driving voltage) and durability. Therefore, a transferring material to form a film of the hole transporting layer may comprise a single material, or may comprise a mixture of a plurality of materials. The hole transporting layer can be formed by various processes in arranging the transferring material within the division pattern as with the emissive layer.

Examples of the hole transporting material include low molecular materials such as aromatic amines typified by N,N'-diphenyl-N,N'-dinaphthyl-1,1'-diphenyl-4,4'-diamine (NPD), N,N'-biphenyl-N,N'-biphenyl-1,1'-diphenyl-4,4'-diamine and N,N'-diphenyl-N,N'-(N-phenylcarbazolyl)-1,1'-diphenyl-4,4'-diamine, and heterocyclic compounds typified by N-isopropylcarbazole, pyrazoline derivatives, stilbene-based compounds, hydrazone-based compounds, oxadiazole derivatives and phthalocyanine derivatives; and polymer materials such as polycarbonate and styrene derivatives, having these low molecular materials on the side chains, polythiophene, polyaniline, polyfluorene, polyvinylcarbazole and polysilane. Examples of the acceptormaterial include lowmolecularmaterials such as 7,7,8,8-tetracyanoquinodimethane (TCNQ), hexaazatriphenylene (HAT) and cyano group derivatives thereof (HAT-CN6). Examples of the hole transporting material or acceptor material also include metal oxides such as molybdenum oxide or silicon oxide which is formed in a small thickness on the surface of the first electrode.

The electron transporting layer may be a single-layer or may be a multi-layer, and a material of each layer may be a single material or may be a mixture of a plurality of materials. The electron transporting layer also includes a layer referred to as a hole blocking layer or an electron injection layer. A donor material, which promotes an electron transporting property, may be mixed in the electron transporting layer from the viewpoint of an electron transporting property (low driving voltage) and durability. The layer referred to as an electron injection layer is often discussed as the donor material. A transferring material to form a film of the electron transporting layer may comprise a single material, or may comprise a mixture of a plurality of materials. The electron transporting layer can be formed by various processes in arranging the transferring material within the division pattern as with the emissive layer.

Examples of the electron transporting material include low molecular materials such as quinolinol complexes such as Alq₃ and (8-quinolinato)lithium (Liq); condensed polycyclic aromatic derivatives such as naphthacene, and anthracene; styryl-based aromatic ring derivatives typified by 4,4'-bis(diphenylethenyl)biphenyl; quinone derivatives such as anthraquinone and diphenoquinone; phosphorus oxide derivatives; benzoquinolinol complexes; hydroxyazole complexes; azomethine complexes; metal complexes such as tropolone metal complexes and flavonol metal complexes; and compounds having a heteroaryl ring structure including electron-accepting nitrogen; and polymer materials having these low molecular materials on the side chains.

Examples of the donor material include alkali metals and alkaline earth metals such as lithium, cesium, magnesium and calcium; metal complexes such as quinolinol complexes of alkali metals or alkaline earth metals; and oxides and fluorides of alkali metals or alkaline earth metals such as lithium fluoride and cesium oxide. The electron transporting material and the donor material is one of materials in which changes in performance tend to occur by the combination with the RGB emissive layer and this is another preferable example patterned according to the present invention.

At least one of the first electrode and the second electrode is preferably transparent in order to take out light emission from the emissive layer. The first electrode is transparent in the bottom emission in which light is taken out from the first electrode and the second electrode is transparent in the top emission in which light is taken out from the second electrode. The first and the second electrodes can be formed by various processes in arranging the transferring material within the division pattern as with the emissive layer. Further, reactive transfer, e. g. , the transferringmaterial is reacted with oxygen, can be carried out in transferring. For a transparent electrode and the other electrode, a publicly known material, for example, a material described in Japanese Unexamined Patent Publication No. 11-214154, can be used.

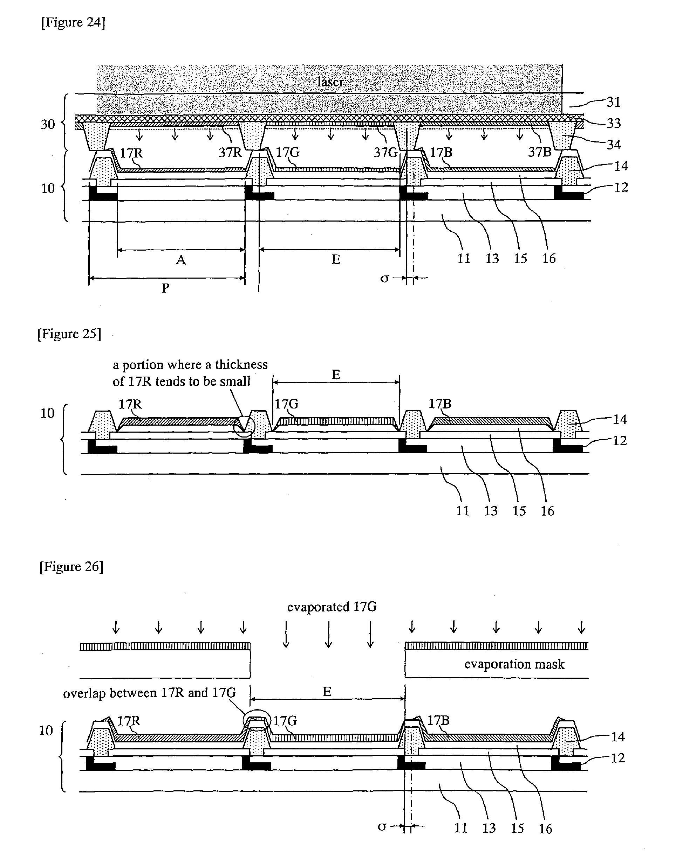

The organic EL device (display) produced according to the present invention has the following characteristics. As shown in Fig. 24, an opening width of the insulating layers 14 adjacent to each other of the device substrate 10 is denoted by A, a width of the emissive layer 17 existing in a region corresponding to the opening is denoted by E, and a pitch of the insulating layer 14 is denoted by P. The P is equal to a pitch of the division pattern of the donor substrate. At this time, in the organic EL device produced according to the present invention, a distance between the emissive layers adjacent to each other in a width direction is almost constant and the relationship of A < E < P is satisfied.

Difference between the organic EL device produced according to the present invention and that produced according to a prior art will be described. The emissive layer 17 is always required to completely cover the opening width A of a subpixel and not to cover an opening region of an adjoining subpixel. Thus, conventionally, a constitution shown in Fig. 25, in which the organic EL device is produced by use of an application method, is considered. Since this method is a patterning method in which the emissive layer 17 is prevented from riding on the insulating layer 14 by making use of "repelling" between an ink and the insulating layer 14, the relationship of E = A is always satisfied. Therefore, a portion where a thickness of the emissive layer 17 is small tends to be formed in the vicinity of the boundary between the insulating layer and the opening, and an electric current is easily concentrated at this portion to cause a short circuit. Furthermore, the hole transporting layer 16 is often formed in a state of being divided into each of RGB subpixels because it is necessary to expose the insulating layer 14 during forming the emissive layer 17.

On the other hand, in accordance with the conventional mask evaporation process shown in Fig. 26, since it is also possible to make the emissive layer 17 rides on the insulating layer 14, the above-mentioned problems do not arise. However, in an actual production process, an alignment error σ may occur in aligning the device substrate 10 with the position of the evaporation mask. Fig. 26 shows a situation in which using the typical condition of E = P, the emissive layers 17R and 17B are patterned at an error of 0 as an example and then the emissive layer 17G is patterned at an error of σ. In this case, since an overlap occurs at a boundary region between the emissive layers 17R and 17G, the distance between these emissive layers is 0 (or a negative value). On the other hand, the distance between the emissive layers 17G and 17B is σ. Since R, G, and B is separately patterned described above and an error of a mask position occurs in each patterning, it is very difficult to keep the distance between the emissive layers constant.

In addition, if the device is designed so as to satisfy the relationship of E < P in the conventional mask evaporation process, a probability that the emissive layer does not completely cover the opening width A of the subpixel increases by the extent corresponding to the relationship, and therefore there is a need for reducing a total error derived by adding on a considerable error, which the evaporation mask itself has, to the alignment error σ, leading to an increase in the burden of facilities. When the error is relatively enough small, generally, the device is designed to increase the opening width A of the subpixel to enhance an aperture ratio of a display. That is, in the conventional mask evaporation process, since even though designing the device so as to satisfy the relationship of E < P, this just results in an increase in required accuracy of an alignment mechanism and a evaporation mask and offers no advantages, the device is commonly designed to have the relationship of E = P.

As distinct from the prior art like this, in the organic EL device produced in accordance with the present invention, the emissive layer is surely formed in an area larger than the opening width on the device substrate. That is, the emissive layer 17 rides on the insulating layer 14 as shown in Fig. 24, or the emissive layer 17 covers an inclined portion of the insulating layer 14 as shown in Fig. 2. Thus, since the relationship of A < E is satisfied and the portion where a thickness of the emissive layer 17 is small does not exist, a short circuit due to current concentration can be inhibited. In addition to this, a distance between the transferred emissive layers adjacent to each other in a width direction is almost constant since transferring is performed by using a donor substrate in which a pitch is fixed in advance (there is exactly an error of the donor substrate itself, but particularly in large substrates, this error can be significantly decreased compared with the error of the evaporation mask itself). As shown in Fig. 24, even if an alignment error σ occurs in aligning the device substrate 10 with the donor substrate 30, this does not affect distances between emissive layers since the same error occurs for all of R, G and B emissive layers. Further, a space (gap) where the semiconductor layer 17 does not exist is found without exception between 17R, 17G, and 17B. Further, the hole transporting layer 16 is often formed so as to cover the insulating layer 14. The organic EL device produced in accordance with the present invention can be differentiated from the conventional organic EL devices in this point.

The difference whether the transferring material is overlaid on the insulating layer 14 or not is similarly recognized in the conventional laser transfer process in which every RGB subpixel is selectively irradiated with laser. It is possible to relatively easily detect, by fluorescence microscope observation, whether the transferring material is overlaid on the insulating layer 14 or not.

The organic EL device in the present invention is characterized by being A < E < P as described above and is further characterized that the flexibility in design of value E is high in contrast to the conventional mask evaporation process, the laser transfer process and the application process. For example, in Fig. 24, if the organic EL device is designed so as to satisfy the relationship of A + 2σ ≤ E, although alignment of the device substrate 10 with the donor substrate 30 causes alignment error σ, it can be ensured that the emissive layer 17 completely covers an opening width between the insulating layers 14 and a problem of a short circuit in an application method can be solved. Since it is difficult to suppress the error σ to 2µm or less, in the organic EL device in the present invention, it is preferred that a width E of the emissive layer 17 is larger than the opening width A between the insulating layers 14 by 4 µm or more. Further, it is preferred that the width E of the emissive layer 17 is smaller than pitches P of the R, the G and the B subpixels by 10µm or more since a width of the division pattern on the donor substrate is preferably 10µm or more in order to surely prevent a mixed color in patterning the transferring material 37 by the application process. By designing the width of the emissive layer 17 of the organic EL device in the present invention so as to satisfy these relationships, the object of the present invention that large size and highly accurate fine patterning is carried out without degrading characteristics of an emissive layer 17 can be achieved. In addition, there may be cases where the width of the subpixel is designed so as to differ from color to color, that is, A, E, P or the distance is designed so as to differ from color to color because of differences in light emission performance between R, G and B. Even in this case, the organic EL device in the present invention is characterized in that the relationship of A < E < P is satisfied and the distance is almost constant for values defined for the respective colors.

The organic EL device in the present invention is not limited to an active matrix type in which a second electrode is commonly formed as a common electrode, and it may be, for example, a passive matrix type including a stripe-like electrode in which the first electrode and the second electrode intersect, or may be a segment type in which a display section is pattered so as to display predetermined information. Examples of the uses of these include a TV set, a personal computer, a monitor, a clock, a thermometer, audio equipment, and a display panel for automobiles.

The patterning method of the present invention can be applied not only to organic EL devices, but also to the devices such as organic TFTs, photoelectric conversion devices, various sensors and the like. For example, as conventional technologies of the organic TFT, a technique, in which a semiconductor layer is formed by directly applying a precursor material of a semiconductor onto a device substrate and then converting the precursor material to a semiconductor, is disclosed in exemplifications in Japanese Unexamined Patent Publication No. 2003-304014, Japanese Unexamined Patent Publication No. 2005-232136, and Japanese Unexamined Patent Publication No. 2004-266157, and if this semiconductor layer is formed by the patterning method of the present invention, it is possible to achieve the same effects as in the organic EL device.

### EXAMPLES

Hereinafter, the present invention will be described by way of examples, but the present invention is not limited to these examples.

### Example 1

A donor substrate was prepared as described below. An alkali-free glass substrate was used as a support and cleaned/treated in the atmosphere of UV-ozone, and then a titanium layer of 1.0 µm in thickness was formed over the entire area of the substrate as a light-to-heat conversion layer by a sputtering process. Next, after the light-to-heat conversion layer (LHCL) was treated in the atmosphere of UV-ozone, a positive type polyimide-based photosensitive coating agent (produced by TORAY INDUSTRIES, INC., DL-1000) was applied onto the LHCL by spin coating, prebaked and exposed to ultraviolet light, and then the exposed area was dissolved in a developer (produced by TORAY INDUSTRIES, INC., ELM-D) and eliminated. The polyimide precursor film thus patterned was baked at 350°C for 10 minutes with a hot plate to form a polyimide-based division pattern. The division pattern had a thickness of 2 µm, a forward tapered cross-section and a width of 20 µm. Openings of 80 µm in width and 280 µm in length through which the light-to-heat conversion layer was exposed were arranged with 100-µm pitches in a width direction and 300-µm pitches in a length direction within the division pattern. A transferring material, consisting of Alq₃ and having an average thickness of 25 nm, was formed within the division pattern (opening) by applying a chloroform solution containing Alq₃ in an amount of 3% by weight onto this substrate by spin coating.

A device substrate was prepared as described below. An alkali-free glass substrate (produced by GEOMATEC Corp., article on which a film is formed by sputtering), on which an ITO transparent conductive film of 140 nm in thickness was deposited, was cut into pieces having a size of 38 mm × 46 mm and the ITO film was etched into a desired shape by a photolithographic process. Next, the polyimide precursor film patterned in the same manner as in the donor substrate was baked at 300°C for 10 minutes to form a polyimide-based insulating layer. The insulating layer had a height of 1.8 µm, a tapered cross-section and a width of 30 µm. Openings of 70 µm in width and 270 µm in length through which the ITO was exposed were arranged with 100-µm pitches in a width direction and 300-µm pitches in a length direction within the pattern of the insulating layer. The substrate was treated in the atmosphere of UV-ozone and then placed in a vacuum deposition apparatus and the apparatus was evacuated until a vacuum in the apparatus reaches below 3 × 10⁻⁴ Pa. Copper phthalocyanine (CuPc) was deposited in a thickness of 20 nm and then NPD was laminated in a thickness of 40 nm as a hole transporting layer over the entire area of an emissive region by evaporation using a resistance-heating evaporation process.

Next, a position of the division pattern of the donor substrate was aligned with the insulating layer of the device substrate with the division pattern opposed to the insulating layer, and these substrates opposed to each other were held in a vacuum of 3 × 10⁻⁴ Pa or less and then taken out to the atmosphere. A transfer space defined by the insulating layer and the division pattern was held at a reduced pressure. In this state, a glass substrate side of the donor substrate was irradiated with laser with a central wavelength of 800 nm (light source: semiconductor laser diode) so that a part of the transferring material and a part of the division pattern are simultaneously heated to transfer Alq₃ of a transferring material on the hole transporting layer which was an underlayer of the device substrate. Laser intensity was about 300 W/mm², a scanning speed was 1.25 m/s, and scanning was repeated by a method in which repeated irradiated laser light overlap one another so as to transfer the transferring material to the entire area of an emissive region.

The device substrate to which Alq₃ was previously transferred was placed in a vacuum deposition apparatus again and the apparatus was evacuated until a vacuum in the apparatus reaches below 3 × 10⁻⁴ Pa. E-1 shown below was vapor-deposited in a thickness of 25 nm as an electron transporting layer over the entire area of an emissive region by a resistance-heating evaporation process. Next, lithium fluoride was vapor-deposited in a thickness of 0.5 nm as a donor material (electron injection layer) and further aluminum was vapor-deposited in a thickness of 100 nm as a second electrode to prepare an organic EL device having an emissive region of 5 mm square.

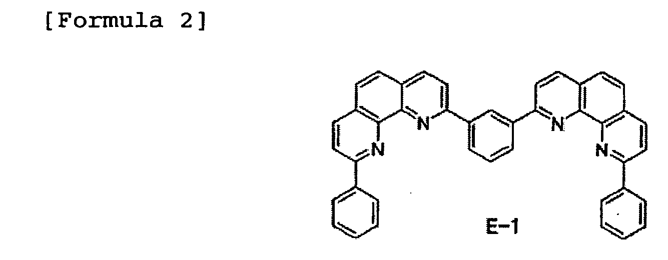

### Example 2

An organic EL device was prepared in the same manner as in Example 1 except for forming a transferring material in which Alq₃ of a host material contains rubrene of a dopant material in an amount of 5% by weight by applying a chloroform solution containing Alq₃ and rubrene in a total amount of 1.5% by weight by spin coating.

### Comparative Example 1

An organic EL device was prepared in the same manner as in Example 1 except for irradiating with laser so as to heat only a transferring material to transfer Alq₃ of a transferring material.

### Comparative Example 2

An organic EL device was prepared in the same manner as in Example 2 except for irradiating with laser so as to heat only a transferring material to transfer a mixture of Alq₃ and rubrene, which were a transferring material.

The organic EL devices prepared in Examples 1, 2 and Comparative Examples 1, 2 were encapsulated, and then a constant electric current of 2.5 mA/cm² was passed. The luminance right after starting passing an electric current was taken as an initial luminance, a value obtained by dividing the initial luminance by a current density was taken as an initial luminance efficiency, and the time that elapsed before the luminance dropped from the initial luminance to one-half under a constant current was taken as a half-life of luminance and these were measured. A relative value of the measurements in Comparative Example 1 in the case where the measurements in Example 1 is taken as 1, and a relative value of the measurements in Comparative Example 2 in the case where the measurements in Example 2 is taken as 1 are respectively taken as a relative initial luminance efficiency and as a relative half-life of luminance and the results are shown in Table 1. Luminance efficiency and durability of the organic EL device was significantly improved by irradiating a transferring material with laser so that at least a part of the transferring material and at least a part of the division pattern are simultaneously heated to transfer the transferring material.

**[Table 1]**

| | transferring material | relative initial luminance efficiency | relative half-life of luminance |
|---|---|---|---|
| Example 1 | Alq₃ | 1 | 1 |
| Comparative Example 1 | Alq₃ | 0.9 | 0.4 |
| Example 2 | Alq₃ and rubrene 5% by weight | 1 | 1 |
| Comparative Example 2 | Alq₃ and rubrene 5% by weight | 0.8 | 0.5 |

### Comparative Example 3

It was tried to prepare an organic EL device in the same manner as in Example 1 except for not forming the light-to-heat conversion layer on the donor substrate, but the transferring material could not adequately absorb laser and therefore adequate transfer could not be carried out.

### Comparative Example 4

It was tried to prepare an organic EL device in the same manner as in Example 1 except that the light-to-heat conversion layer was not formed on the donor substrate and laser was irradiated at an intensity five times larger than Example 1, but since the transferring material could not adequately absorb laser, adequate transfer could not be carried out and a phenomenon, in which the device substrate was heated due to laser leakage and a hole transporting layer adhered to the donor substrate, was found. Furthermore, thermal degradation or a deformation of a division pattern of the donor substrate and occurrence of outgassing were recognized.

### Example 3

A donor substrate was prepared in the same manner as in Example 1 except that a tantalum layer of 0.4 µm in thickness was formed over the entire area of the substrate as a light-to-heat conversion layer by a sputtering process and a division pattern of 7 µm in thickness and 20 µm in width was formed. A transferring material having a thickness of 38 nm was formed by co-evaporating a pyrene-based red host material RH-1 and a pyrromethene-based red dopant material RD-1 (0.5% by weight with respect to the host material) over the entire area on the donor substrate. A device substrate was also prepared in the same manner as in Example 1 except for changing the height and the width of the insulating layer to 2 µm and 30 µm, respectively and changing a size of the opening through which an ITO was exposed to the air to a size of 70 µm in width and 250 µm in length. An amine-based compound and NPD were vapor-deposited in thicknesses of 50 nm and 10 nm, respectively, as a hole transporting layer over the entire area of an emissive region of the substrate in the same manner as in Example 1.

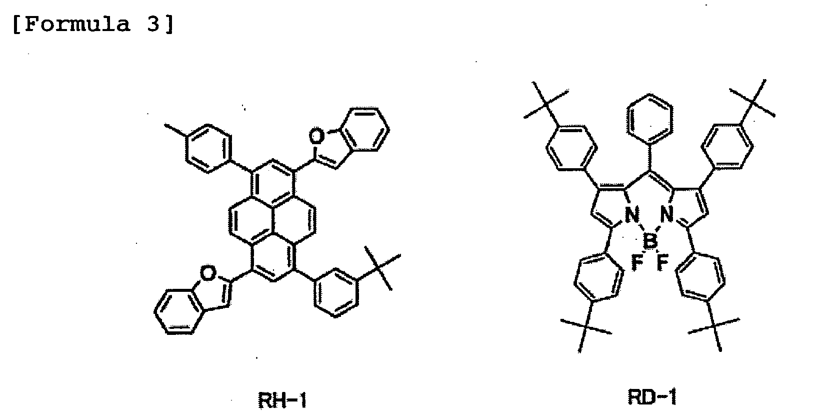

Next, a position of the division pattern of the donor substrate was aligned with the insulating layer of the device substrate with the division pattern opposed to the insulating layer, and these substrates opposed to each other were held in a vacuum of 3 × 10⁻⁴ Pa or less and then taken out to the atmosphere after sealing a peripheral portion of the opposed substrates. A transfer space defined by the insulating layer and the division pattern was held at a vacuum. Light (light source: semiconductor laser diode), which has a central wavelength of 940 nm and was formed into a rectangular irradiation shape of 50 µm long and 340 µm wide, was used for transfer. A glass substrate side of the donor substrate was irradiated with light in such a way that longitudinal directions of the division pattern and the insulating layer agree with a longitudinal direction of the irradiation shape of the light and light was scanned in the longitudinal direction so that the transferring material and the division pattern were simultaneously heated, and thereby a co-evaporation film of a transferring material was transferred on the hole transporting layer which was an underlayer of the device substrate. Light intensity was adjusted within the range of 140 to 180 W/mm² and a scanning speed was 0.6 m/s. Scanning was repeated while making optical paths in scanning overlap one another with about 300-µm pitches so as to transfer the transferring material to the entire area of an emissive region.

An electron transporting layer E1 was vapor-deposited in a thickness of 30 nm on the device substrate to which the co-evaporation film was previously transferred and lithium fluoride and aluminum were vapor-deposited in thicknesses of 0.5 nm and 100 nm, respectively, in the same manner as in Example 1 to prepare an organic EL red device having an emissive region of 5 mm square.

Measurements of the light intensity, number of transfers and luminance efficiency are shown in Table 2. That the number of transfers is 1 means that a full film thickness of the transferring material of 38 nm in thickness is just transferred by irradiating with light one time, and that the number of transfers is 24 means that a full film thickness of the transferring material of 38 nm in thickness is just transferred by irradiating with light 24 times (an average thickness of film transferred by irradiating with light one time is about 1. 6 nm). Clear red light emissions could be identified in each device, and it could be confirmed that the emissive layer transferred covers an opening of the insulating layer of the device substrate in full measure.

**[Table 2]**

| light intensity (W/mm²) | number of transfers | luminance efficiency (cd/A) |
|---|---|---|
| 179 | 1 | 0.2 |
| 153 | 12 | 2.6 |
| 148 | 24 | 5.3 |
| 143 | 36 | 5.2 |

### Example 4

A donor substrate was prepared in the same manner as in Example 3 except that a molybdenum layer of 0.4 µm in thickness was formed over the entire area of the substrate as a light-to-heat conversion layer by a sputtering process. A solution, which was formed by dissolving an RH-2 precursor having a diketone-bridged structure as a soluble group and a pyrromethene-based red dopant material RD-1 in concentrations of 1% by weight and 0.05% by weight, respectively, in tetrahydronaphthalene (THN), was prepared. This solution was applied onto the donor substrate by an ink-jet printing and dried to form a mixed film of the RH-2 precursor and the red dopant material within a division pattern. The mixed film was irradiated with blue light with a central wavelength of 460 nm (light source: light emitting diode) for five minutes in a vacuum to detach the diketone-bridged structure from the RH-2 precursor and convert the RH- 2 precursor to a red host material RH- 2 . Thus, a transferring material, consisting of a mixed film of a red host material and a red dopant material and having an average film thickness of 40 nm, was formed within a division pattern of the donor substrate.

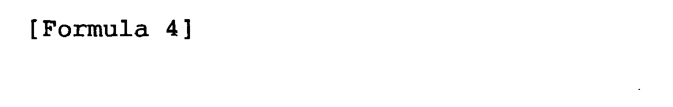

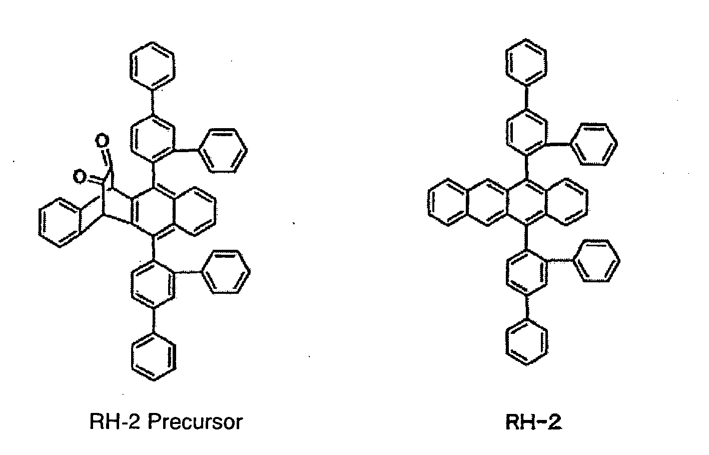

Transferring was repeated 24 times setting laser intensity at 148 W/mm² and an organic EL red device was prepared in the same manner as in Example 3, and consequently clear red light emission was identified.

### Example 5

A donor substrate was prepared in the same manner as in Example 4. The division pattern had a width of 20 µm. The number of openings of 80 µm in width (E = 80 µm) and 280 µm in length, through which the light-to-heat conversion layer was exposed and which were arranged with 100-µm pitches in a width direction (P = 100 µm) and 300-µm pitches in a length direction within the division pattern, was 768 in a width direction and 200 in a length direction. An R solution was prepared by dissolving a pyrene-based red host material RH-1 and a pyrromethene-based red dopant material RD-1 in concentrations of 1% by weight and 0.05% by weight, respectively, in THN, a G solution was prepared by dissolving a pyrene-based green host material GH-1 and a coumarin-based green dopant material (C545T) in concentrations of 1% by weight and 0.05% by weight, respectively, in THN, and a B solution was prepared by dissolving a pyrene-based blue host material BH-1 in a concentration of 1% by weight in THN. By applying these solutions onto the donor substrate by an ink-jet printing and drying these solutions, a donor substrate was prepared, in which an R transferring material, consisting of a mixed film of a red host material and a red dopant material and having an average film thickness of 40 nm, a G transferring material, consisting of a mixed film of a green host material and a green dopant material and having an average film thickness of 30 nm, and a B transferring material, consisting of a blue host material and having an average film thickness of 20 nm, were formed and arranged repeatedly in this order in a width direction of the division pattern.

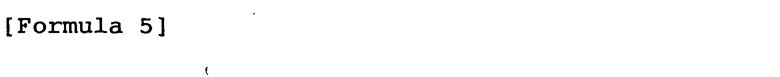

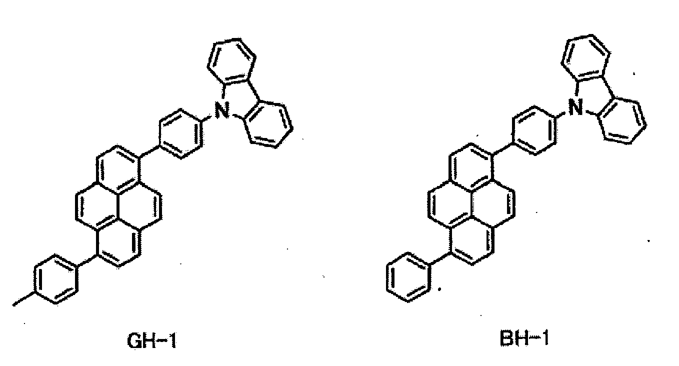

A device substrate was prepared in the same manner as in Example 3. The ITO was previously patterned into the form of 716 stripes with 100-µm pitches, and the opening of the insulating layer through which the ITO was exposed had a width of 70 µm (A = 70 µm) and a length of 250 µm. 716 openings were arranged with 100-µm pitches in a width direction (P = 100 µm) and 200 openings were arranged with 300-µm pitches in a length direction. A longitudinal direction of the ITO stripe electrode was aligned with a longitudinal direction of the insulating layer.

A position of the donor substrate was aligned with that of the device substrate with the donor substrate opposed to the device substrate (alignment error of an alignment mechanism was ±2 µm), transferring was repeated 24 times setting a laser intensity at 148 W/mm² and an organic EL device was prepared in the same manner as in Example 3. In this time, aluminum was patterned into the form of 200 stripes with 300-µm pitches by mask evaporation and a longitudinal direction of the stripe electrode was aligned with a width direction of the insulating layer. Therefore, the prepared organic EL device has a structure of a passive matrix display in which the first electrode including an ITO stripe and the second electrode including an aluminum stripe are orthogonal to each other, and has 256 × 200 pixels composed of R, G and B subpixels arranged at a point of intersection of both electrodes. In R, G and B subpixels, respectively, clear R, G and B light emissions were identified and color mixing between subpixels was not recognized.

### Comparative Example 5

An organic EL device was prepared in the same manner as in Example 5 except that a light-to-heat conversion layer was irradiated with light so as to heat only a transferring material by use of light formed into a rectangular irradiation shape of 50 µm long and 80 µm wide and thereby R, G and B transferring materials were transferred separately. However, since a portion of the emissive layer having a smaller thickness than that of a central portion of the emissive layer was formed in the vicinity of a long side of four sides of a rectangular subpixel, there was a phenomenon that an electric current was concentrated at this portion to cause relatively bright light emission and a short circuit in a short time.

### Comparative Example 6

An organic EL device was prepared in the same manner as in Example 5 except for not forming the division pattern on the donor substrate. However, the transferring materials adjacent to one another were mixed in one another immediately after the solution was applied, and the boundaries between the dried R, G and B transferring materials were not clear. Moreover, in the transfer by one operation, these mixed regions were transferred concurrently with the transferring material. Since a part of the mixed regions was deposited on a top surface of the insulating layer of the device substrate, this part did not have the effect on light emission, but since the other part of the mixed regions was transferred into the pixels, there was a problem that emitted colors of the organic EL device vary somewhat from subpixel to subpixel due to mixed color and the emitted color in the subpixel was uneven.

### Example 6

A donor substrate was prepared in the same manner as in Example 5. However, the division pattern had a width of 26µm and the opening, throughwhich the light-to-heat conversion layer was exposed, had a width of 74 µm (E = 74 µm) and a length of 274 µm. A position of the donor substrate was aligned with that of the device substrate (A = 70 µm, P = 100 µm) identical to that of Example 5 with the donor substrate opposed to the device substrate (alignment error of an alignment mechanism was ±2 µm), transferring was repeated 24 times setting a laser intensity at 148 W/mm² and an organic EL device (passive matrix display) was prepared in the same manner as in Example 5. Clear R, G and B light emissions were identified in R, G and B subpixels, respectively, and it could be confirmed from observation of a fluorescence microscope that the emissive layer of each color completely covers an opening width of the corresponding subpixel.

### Example 7

An organic EL device (passive matrix display) was prepared in the same manner as in Example 6 (A = 70 µm, P = 100 µm). However, the division pattern of the donor substrate had a width of 28 µm and the opening, through which the light-to-heat conversion layer was exposed, had a width of 72 µm (E = 72 µm) and a length of 272 µm. In two organic EL devices of three organic EL devices prepared, clear R, G and B light emissions were identified in R, G and B subpixels, respectively, and it could also be confirmed from observation of a fluorescence microscope that the emissive layer of each color completely covers an opening width of the corresponding subpixel. However, in the rest one organic EL device, it was found that the emissive layer does not completely cover the opening of at least the R pixel and an area, in which the hole transporting layer contacts directly with the electron transporting layer without an emissive layer interposed, exists slightly. A trace of blue light emission (light emission from the hole transporting layer) was identified in this area.

### Example 8

An organic EL device (passive matrix display) was prepared in the same manner as in Example 6 (A = 70 µm, P = 100 µm). However, the division pattern of the donor substrate had a width of 10 µm and the opening, through which the light-to-heat conversion layer was exposed, had a width of 90 µm (E = 90 µm) and a length of 290 µm. Clear R, G and B light emissions were identified in R, G and B subpixels, respectively, and it could also be confirmed from observation of a fluorescence microscope that the emissive layer of each color completely covers an opening width of the corresponding subpixel.

### Example 9

An organic EL device (passive matrix display) was prepared in the same manner as in Example 6 (A = 70 µm, P = 100 µm). However, the division pattern of the donor substrate had a width of 6 µm and the opening, through which the light-to-heat conversion layer was exposed, had a width of 94 µm (E = 94 µm) and a length of 294 µm. Since a width of the division pattern is narrow, an adhesive force between the division pattern and the substrate was reduced and a part of the division pattern was chipped. Furthermore, when the transferring material was formed by ink- j et printing, an area, in which the ink was mixed with that in an adjoining opening through the above-mentioned chipped portion or the ink overstrided a part of the narrow division pattern and mixed with that in an adjoining opening, was formed. Clear R, G and B light emissions were identified in most R, G and B subpixels of the organic EL device, respectively, and it could also be confirmed from observation of a fluorescence microscope that the emissive layer of each color completely covers an opening width of the corresponding subpixel. However, mixed transferring materials were transferred to a part of the subpixels and mixed colors were also identified from light emission.

### Industrial Applicability

The present invention pertains to a technology of patterning thin films composing devices such as organic EL devices, organic TFTs, photoelectric conversion devices, various sensors and the like, and can be used for the production of display panels used in cellular phones, personal computers, television sets, image scanners and the like, and the production of touch panels and imaging devices.

### DESCRIPTION OF THE REFERENCE NUMERALS AND SYMBOLS

- 10: organic EL device (device substrate)
- 11: support
- 12: TFT (including a contact electrode)
- 13: planarization layer
- 14: insulating layer
- 15: first electrode
- 16: hole transporting layer
- 17: emissive layer
- 18: electron transporting layer
- 19: second electrode
- 20: device substrate
- 21: support
- 27: transferred layer
- 30: donor substrate
- 31: support
- 33: light-to-heat conversion layer
- 34: division pattern
- 37: transferring material
- 38: transferring region
- 39: transfer assist layer
- 41: photomask
- 42: lens
- 43: mirror
- 44: light source
- 45: virtual focus-plane

## Claims

1. A patterning method, wherein a donor substrate, in which a light-to-heat conversion layer and a division pattern are formed on a substrate and a transferring material exists within said division pattern, is opposed to a device substrate and said transferring material is transferred on the device substrate by irradiating the light-to-heat conversion layer with light so that at least a part of said transferring material and at least a part of said division pattern are simultaneously heated.

2. The patterning method according to claim 1, wherein the light-to-heat conversion layer is irradiated with a light, a width of which is wider than a width of the transferring material existing within the division pattern.

3. The patterning method according to claim 1 or 2, wherein a donor substrate, in which two or more types of different transferring materials exist, is used and said two or more types of different transferring materials are transferred by one operation by irradiating a light-to-heat conversion layer with a light, a width of which is wider than a total width of widths of said two or more types of different transferring materials and widths of a division pattern existing between these transferring materials.

4. The patterning method according to any one of claims 1 to 3, wherein by repeating light irradiation of the light-to-heat conversion layer plural times, at least one transferringmaterial is transferred divided in multiple steps in a thickness direction.

5. The patterning method according to any one of claims 1 to 4, wherein a solution containing at least a transferring material and a solvent is applied within a division pattern, said solvent is evaporated, and then said transferring material is transferred.

6. The patterning method according to claim 5, wherein at least one transferring material has a group which is soluble in a solvent at the time of applying the transferring material, said soluble group is converted or detached by heat or light after applying the transferring material, and then said transferring material is transferred.

7. A production method of a device, wherein at least one layer of layers composing the device is patterned by the method according to any one of claims 1 to 6.

8. A device having a substrate, an insulating layer formed on said substrate and at least a thin film layer formed between said insulating layers, wherein when an opening width of the insulating layers adjacent to each other is denoted by A, a width of the thin film layer existing in a region corresponding to the opening is denoted by E, and a pitch of the insulating layer is denoted by P, the relationship of A < E < P is satisfied and a distance between the thin film layers adjacent to each other in a width direction is almost constant.

9. The device according to claim 8, wherein said device satisfies a relationship of A + 4 (µm) ≤ E (µm) ≤ P - 10 (µm).

10. The device according to claim 8 or 9, wherein a thin film layer is an emissive layer and the device is an organic EL device.
